# EUROPEAN PATENT SPECIFICATION

(11) **EP 4 411 401 B1**
(45) Date of publication and mention of the grant of the patent: **15.04.2026**
(21) Application number: 23154352.1
(22) Date of filing: 31.01.2023
(51) Int. Cl.: G01R 31/3835, G01R 31/385, G01R 31/392, G01R 31/396

(54) **DEVICES, SYSTEMS, AND METHODS FOR USE WITH ELECTRIC BATTERY CELLS UNDERGOING MATURATION**
VORRICHTUNGEN, SYSTEME UND VERFAHREN ZUR VERWENDUNG MIT REIFUNGSBEHANDELTEN ELEKTRISCHEN BATTERIEZELLEN
DISPOSITIFS, SYSTÈMES ET PROCÉDÉS DESTINÉS À ÊTRE UTILISÉS AVEC DES CELLULES DE BATTERIE ÉLECTRIQUE SUBISSANT UNE MATURATION

(43) Date of publication of application: 07.08.2024
(73) Proprietor: Dukosi Limited, Edinburgh EH3 8RA (GB)
(72) Inventor: LEWORTHY, Josh Robert, Edinburgh, EH3 8RA (GB); CRYMBLE, Timothy William, Edinburgh, EH3 8RA (GB); SYLVESTER, Joel, Edinburgh, EH3 8RA (GB)
(74) Representative: Finnegan Europe LLP

(56) References cited:
- EP-A1- 4 113 140
- CN-A- 111 046 550
- US-A1- 2020 225 290

## Description

### Technical Field

The present disclosure relates to the field of battery technology and energy cells. **In** particular, disclosed embodiments relate to methods, systems, and devices used in production of battery cells and batteries, and more specifically for use with electric battery cells undergoing maturation.

### Background

Battery systems including a plurality of battery cells are used in a wide range of modern electric power applications. For example, battery systems are used in industrial applications (such as transportation, e.g., powering electric vehicles and power grids) and commercial applications (e.g., powering electronic devices, including laptop computers, mobile devices, medical devices, etc.). Given the relatively high-power demands of such applications, a battery system often includes a plurality of battery cells coupled together in series, parallel, or mixture of both, to achieve a required power output. Battery cells may be coupled together to form a battery pack, where the battery system may include one or more battery packs. Safe and effective battery systems require functional battery cells of good and consistent quality.

Production of electric battery cells, such as lithium-ion battery cells, involves multiple stages, including formation, maturation, and shipping. During the formation stage, manufacturers subject newly assembled cells to controlled charge and discharge cycles to prepare the cells for service. Once the cells leave the formation stage, their Open Circuit Voltage (OCV) is measured, and visual checks are performed. The OCV is the voltage measured at cell terminals of the cell when no load is connected to the cell and after the cell has relaxed for a period of time. Thereafter, the maturation stage starts. Maturation is also known as ageing.

The main purpose of the maturation stage is to allow the electrochemical processes started during the formation stage to stabilise (throughout this disclosure also referred to as "to mature"), and once such processes have stabilised, to check the integrity of the newly assembled cells, rejecting weak or defective cells before they are brought into service, such as before they are shipped to customers. The electrochemical processes however will continue for the duration of cells' lifetime, after the maturation stage, as defined by the cell manufacturer, ends. During the maturation stage, manufacturers commonly store cells at a manufacturing facility, e.g., on a shelf, typically in a controlled environment, for a given period of time (may be referred to as a "maturation period"), during which the cells are undergoing maturation/ageing. The length of the maturation period is such as to allow for possible manufacturing defects or faults to manifest or become evident in the cells, while the cells are still at the manufacturing facility. During storage for maturation, the cells are not electrically connected, i.e., both of their terminals are floating with respect to any external power source. The maturation stage usually takes place at an elevated temperature, e.g., 40 degrees Celsius, to promote or accelerate electrochemical processes within the cells. Such an elevated temperature also increases the self-discharge of the cells, thereby facilitating easier identification of cell defects or faults, if any.

After the maturation period, the OCV of the cells is measured again. If the decrease in OCV from the measurement taken before the maturation period to the measurement taken after the maturation period is greater than a predetermined voltage (typically, a threshold set by the cell manufacturer), the cell is rejected as being unfit for service. The OCV check would show any cells that have a higher rate of self-discharge than expected for a properly functioning cell. No significant change in the cell properties over the entire maturation period, after the initial maturation settling, shows that the cell is functional and of good quality.

To evaluate the cells, other measurements can be taken, and tests performed, such as pulse tests, internal resistance measurements, optical inspections, and leakage tests.

Those cells that are deemed good and functional are then discharged or charged to their final shipping voltage for shipping.

The formation and maturation process may be interlaced. In such a case, a cell will be partially formed, left to mature for a period of time, and then proceed to the final formation stage, followed by the final maturation stage. The partial formation and maturation stages may be repeated before the final formation and maturation stages are reached. Sometimes, these interlaced processes may include high temperature and low temperature ageing/maturation processes. For example, a small charge can be applied to a cell (formation), before the cell is allowed to age (mature) for a period of time, while being exposed to a high temperature. Then another charge is applied to the cell (formation), before the cell is allowed to age (mature) for another period of time, but at a low temperature.

The maturation stage is intended to allow for detection of defects of unduly high self-discharge rate, as well as electrolyte seal leaks, mechanical defects, unduly high internal resistance caused by a malformed Solid Electrolyte Interphase (SEI) layer, and the like, before the cells leave a manufacturer's facility. Some defects however take an extended time to manifest in cells, e.g., in the terms of days or weeks. Therefore, a maturation period for a cell is usually of an extended length, from days to many weeks. The length of the maturation (ageing) stage or period may depend on the cell type, chemistry, and the manufacturer's confidence and/or knowledge of the cell quality.

The maturation stage is also one of the more dangerous amongst the stages of manufacture due to a potential fire hazard presented by defective cells. As such, the maturation stage typically takes place at a fire-proof facility with expensive fire suppression systems.

Accordingly, the maturation stage is often one of the more expensive stages in cell production or manufacture, particularly due to the substantial amount of temperature-controlled and fire-proof space and expensive equipment, both required for prolonged periods of time to allow execution of the maturation stage. Document US 2020/225290 A1 discloses a cell monitoring device for electric battery cells undergoing maturation in a controlled environment, wherein the device measures voltage of the battery cells at a sampling rate and calculates a rate of change of voltage based on the voltage measurements relative to the sampling rate, wherein the cell monitoring device determines if the electric battery cell deviates from a manufacturing specification.

### Summary

In accordance with aspects of the present disclosure, there is provided a cell monitoring device, CMD, for use with an electric battery cell while the electric battery cell is electrically coupled to the CMD and undergoing maturation in a controlled environment, after being charged. The CMD comprises: circuitry configured to execute operations for causing the CMD to, repeatedly: obtain, using a voltage sensor, voltage measurements of the electric battery cell, at a sampling rate, calculate a rate of change for voltage based on the voltage measurements relative to the sampling rate, and evaluate the obtained voltage measurements and the calculated rate of change using a model defined for the electric battery cell according to a manufacturing specification of the electric battery cell, to determine whether the electric battery cell deviated from the manufacturing specification, or reached a predetermined stage of maturation for removing the electric battery cell from the controlled environment, the model comprising one or more voltage-dependent functions. The circuitry is also configured to execute operations for causing the CMD to: upon determining that the electric battery cell reached the predetermined stage of maturation for removing the electric battery cell from the controlled environment, generate a corresponding alert.

The one or more voltage-dependent functions comprise a function for defining a state of maturation of the electric battery cell in which a probability of the electric battery cell exhibiting a manufacturing fault while continuing to undergo maturation is below a predetermined level.

The function for defining the state of maturation may comprise a range for a second derivative of voltage of the electric battery cell over time.

The circuitry may be configured to execute operations for causing the CMD to determine that the electric battery reached the predetermined stage of maturation upon determining that the second derivative of voltage over time of the electric battery cells is within the range for the second derivative defined by the corresponding function and that the electric battery cell has not deviated from the manufacturing specification.

The model may comprise a voltage-dependent function defining expected changes in voltage of the electric battery cell indicative of as-expected maturation when exhibited by the electric battery cell undergoing maturation.

Additionally or alternatively, the model may comprise a voltage-dependent function defining one or more voltage thresholds indicative of a manufacturing fault at the electric battery cell when crossed by the voltage of the electric battery cell.

Additionally or alternatively, the model may comprise a voltage-dependent function defining changes in voltage indicative of a manufacturing fault at the electric battery cell when exhibited by the voltage of the electric battery cell.

Additionally or alternatively, the model may comprise a voltage-dependent function defining expected changes in a rate of change of voltage indicative of as-expected maturation when exhibited by the electric battery cell undergoing maturation.

Additionally or alternatively, the model may comprise a voltage-dependent function defining one or more rate thresholds indicative of a manufacturing fault when crossed by the rate of change of voltage of the electric battery cell.

Additionally or alternatively, the model may comprise a voltage-dependent function defining changes in the rate of change of voltage indicative of a manufacturing fault at the electric battery cell when exhibited by the rate of change of voltage of the electric battery cell.

The model may comprise one or more tolerances defined for at least one of the voltage-dependent functions used when evaluating the voltage measurements or the calculated rate of change.

The one or more tolerances defined for the at last one voltage-dependent function may be time-dependent relative to the electric battery cell undergoing maturation and/or adjustable based on a state of the controlled environment.

The circuitry may be configured to execute operations for causing the CMD to: obtain one or more property measurements of a property of the electric battery cell, in addition to voltage, using a corresponding sensor, the electric battery cell having a plurality of properties including voltage; and evaluate the obtained one or more property measurements using the model to determine whether the electric battery cell deviated from the manufacturing specification, the model comprising at least one property-dependent functions corresponding to the property.

The circuitry may be configured to execute operations for causing the CMD to obtain and evaluate the one or more property measurements for different properties of the electric battery cells in addition to voltage.

The circuitry may be configured to execute operations for causing the CMD to repeatedly obtain and evaluate the one or more property measurements.

The CMD may be configured for embedding into the electric battery cell.

The CMD may be configured for attaching to the electric battery cell.

The CMD may be configured for subsequent removal from the electric battery cell.

The CMD may be configured to be the sole electrical load of the electric battery cell while the electric battery cell is undergoing maturation in the controlled environment.

The CMD may comprise memory.

The circuitry may be configured to execute functions for causing the CMD to store property measurements obtained at the electric battery cell and resulting calculations in the memory of the CMD for subsequent retrieval by the CMD or a remote controller, including after the electric battery cell reached the predetermined stage of maturation.

The model may be stored in the memory of the CMD.

In accordance with aspects of the present disclosure, there is provided a cell monitoring system, CMS, for use with a plurality of electric battery cells while the plurality of electric battery cell is undergoing maturation in a controlled environment, after being charged. The system comprises a plurality of CMDs, each CMD being configured to be electrically coupled to one the plurality of electric battery cells. The CMS also comprises a controller in communication with the plurality of CMDs, such as CMDs described throughout this disclosure, wherein each CMD is configured, upon determining that the corresponding electric battery cell deviated from the manufacturing specification or reached the predetermined stage of maturation, transmit the corresponding alert to the controller.

In accordance with aspects of the present disclosure, there is provided a cell monitoring system, CMS, for use with a plurality of electric battery cells while the plurality of electric battery cells is undergoing maturation in a controlled environment, after being charged. The CMS comprises: a plurality of cell monitoring devices, CMDs, each CMD configured to be electrically coupled to one of the plurality of electric battery cells; and a controller in communication with the plurality of CMDs. Each of the plurality of CMDs comprises circuitry configured to execute operations for causing the CMD to: repeatedly, obtain, using a voltage sensor, voltage measurements of the electric battery cell, at a sampling rate, calculate a rate of change for voltage based on the voltage measurements relative to the sampling rate, and transmit the voltage measurements and the calculated rate of change to the controller. For each of the plurality of CMDs the controller is configured to: evaluate the received voltage measurements and rate of change using a model, defined for the electric battery cell according to a manufacturing specification of the electric battery cell, to determine whether the electric battery cell deviated from the manufacturing specification, or reached a predetermined stage of maturation for removing the electric battery cell from the controlled environment, the model comprising one or more voltage-dependent functions, the one or more functions comprising a function for defining a state of maturation of the electric battery cell in which a probability of the electric battery cell exhibiting a manufacturing fault while continuing to undergo maturation is below a predetermined level, the function used determine that the electric cell reached the predetermined stage of maturation, and generate, upon determining that the electric battery cell reached the predetermined stage of maturation for removing the electric battery cell from the controlled environment, a corresponding alert.

The model may be the same for the plurality of electric battery cells where the electric battery cells are of the same type.

For each of the plurality of CMDs, the circuitry of the CMD may be configured to execute operations for causing the CMD to obtain one or more property measurements of a property of the electric battery cell, in addition to voltage, using a corresponding sensor, the electric battery cell having a plurality of properties including voltage, and transmit the obtained one or more property measurements to the controller. The controller may be configured to evaluate the received one or more property measurements using the model to determine whether the electric battery cell deviated from the manufacturing specification, the model comprising at least one property-dependent functions corresponding to the property.

For each of the plurality of CMDs, the circuitry of the CMD may be configured to execute operations for causing the CMD to obtain and transmit to the controller the one or more property measurements for different properties of the electric battery cells in addition to voltage.

For each of the plurality of CMDs, the circuitry may be configured to execute operations for causing the CMD to repeatedly obtain and transmit to the controller the one or more property measurements.

### Brief Description of Drawings

The accompanying drawings, which are incorporated in and constitute a part of this disclosure, illustrate disclosed embodiments and, together with the description, serve to explain the disclosed embodiments. In the drawings:
Figure 1 illustrates an example of cell monitoring device, according to some embodiments.
Figure 2 illustrates an example of a method for monitoring a maturation stage of a cell, according to some embodiments.
Figure 3A depicts two exemplary voltage-over-time functions corresponding respectively to two electric battery cells of the same type undergoing maturation.
Figure 3B depicts rate of change of voltage-over-time functions corresponding to the voltage-over-time functions shown in Figure 3A.
Figure 4 illustrates an example of a method for monitoring a maturation stage of a cell, according to some embodiments.
Figure 5 depicts three exemplary functions of temperature over time corresponding respectively to three different pouch cells undergoing maturation.
Figure 6 depicts three exemplary functions of pressure over time corresponding respectively to three different pouch cells undergoing maturation.
Figure 7 depicts three exemplary functions of cell strain over time corresponding respectively to three different pouch cells undergoing maturation.
Figure 8 depicts three exemplary functions of cell mass over time corresponding respectively to three different pouch cells undergoing maturation.
Figure 9 depicts a method for monitoring maturation of an electric battery cell according to some embodiments.
Figure 10 depicts an example of a cell monitoring system for monitoring maturation of electric battery cells in a controlled environment, according to some embodiments.

### Detailed Description of Embodiments

In the following description, certain aspects and embodiments of the present disclosure will become evident. It should be understood that the disclosure, in its broadest sense, could be practiced without having one or more features of these aspects and embodiments. It should also be understood that these aspects and embodiments are merely exemplary.

The following detailed description refers to the accompanying drawings. Wherever possible, the same or similar reference numbers are used in the drawings and the following description to refer to the same or similar parts or components. While several illustrative embodiments and aspects are described herein, modifications, adaptations and other implementations are possible. For example, substitutions, additions, or modifications may be made to the parts and components illustrated in the drawings, and the illustrative methods described herein may be modified by substituting, reordering, removing, or adding steps to the disclosed methods. Accordingly, the following detailed description is not limited to the disclosed embodiments, aspects, and examples. Instead, the proper scope is defined by the appended claims.

Known implementations of a maturation stage of electric battery cells, such as the approaches discussed in the "Background" section of this document, present a number of problems for battery cell manufacturers. For example, some implementations introduce a significant delay between manufacturing or assembling of electric battery cells and their shipment, in order to allow the cells to mature prior to being shipped. This means that valuable assets are held up in the process, and any batch production issues can take weeks to identify.

Additionally, a maturation storage area often uses a substantial proportion of a manufacturing facility floor, such as more than 50% of the entire floor space. To ensure fire safety of the manufacturing facility, the maturation storage area needs to be fire-proof and include fire suppression systems, which are typically costly. Further, as maturation is usually performed in a temperature-, and sometimes humidity-, controlled environment, the floor space used for maturation of electric battery cells must be temperature-, and possibly humidity-, controlled. These controlled environments are expensive to run. Consequently, the floor space used for the maturation storage area is expensive to set-up and run.

Usually, cell manufacturers take cell measurements at the beginning and end of a maturation period predefined (or preset) by a cell manufacturer. This means that notwithstanding when a particular defect manifests itself in a cell, the cell manufacturer would only become aware of that defect at the end of that maturation period, at the earliest. That is, detection of defects that occur before the end of the maturation stage set by the cell manufacturer is delayed until after the maturation period is complete. Thus, the manufacturer misses on an opportunity to identify such defects early in the manufacturing process, as well as to rectify production issues that could have caused such defects early in the manufacturing process, thereby allowing for further manufacture of defective cells.

At least some embodiments of the present disclosure provide solutions for managing or monitoring maturation of electric battery cells using a cell monitoring (or measuring) device (CMD), which may be used to address one or more of the above-discussed shortcomings.

For example, by integrating a CMD with or attaching the CMD to an electric battery cell, removably or permanently, to monitor a range of cell properties, while the electric battery cell undergoes maturation in a controlled environment, cell defects can be identified at or around the time of their manifestation. Such early identification of cell defects enables manufacturers to detect or predict cell failures during the maturation stage, including early on in the maturation stage, thereby helping the manufacturers to identify problems with cell production process(es) early on. The manufacturers then have an opportunity to prevent continued production of faulty cells, and rectify the identified problems with the cell production process(es). This early identification of cell defects also provides an option to the manufacturers to remove defective or weak cells from the maturation stage early, freeing up space for other cells.

Additionally, early identification of hazardous faults, such as faults that may result in fire, and correcting the production process(es) accordingly, can help with reducing the risk of catastrophic events occurring during the maturation stage.

Also, in accordance with at least some of the disclosed embodiments, while electric battery cells undergo maturation in a controlled environment, such electric battery cells are monitored using CMDs incorporated with or attached to the electric battery cells and corresponding data, such as gathered and/or processed measurements of cell properties, are stored locally at CMDs. Use of such data allows for reduction in the number of end-of-line tests needed to assess the integrity of manufactured cells once the maturation stage finishes. This in turn reduces the capital equipment required for the maturation stage.

In some embodiments, a CMD is incorporated with a corresponding cell for the duration of that cell's lifetime. When the cell becomes a part of a battery, the CMD can then be used as part of a battery management system (BMS), enabling connection between the cell and BMS, including for communicating measurements obtained at the cell and/or results of analysis of such measurements.

Additionally, at least some of the disclosed embodiments provide for constant or continuous monitoring of electric battery cells that would allow cell manufacturers to push some parts of the maturation stage into other stages, such as shipping and/or storage. For example, according to at least some of the disclosed embodiments, once an electric battery cell reaches a state at which it has experienced sufficient electrochemical changes so that it is not likely thereafter to develop or exhibit a manufacturing fault (e.g., determined and defined by a cell manufacturer with a predefined level of confidence using functions defining expected behaviour of cell properties, such as pre-set threshold values for various cell's measurements), such an electric battery cell can be removed from the controlled environment to continue undergoing maturation outside the controlled environment, for example during shipping. Such early cell removal would allow cell manufacturers to free up space for other cells early on, as well as to ship the cells earlier than would be done using the approaches described in the background section of this document. This in turn speeds up throughput.

Additionally, at least some of the disclosed embodiments provide for on-going (e.g., periodic, constant, or continuous) monitoring of electric battery cells that would allow cell manufacturers to determine, in substantially real time (as it happens), when an electric battery cell has matured sufficiently (the electrochemical processes started during the formation stage have sufficiently stabilised) so that the electric battery cell is unlikely to develop a manufacturing fault thereafter. For example, by evaluating changes in cell's properties over time in comparison to a modelled or exemplar behaviour for an electric battery cell of the same type, it could be determined with a certain level of confidence whether the electric battery cell is likely to develop or exhibit a manufacturing fault thereafter. Thus, cell manufacturers no longer need to rely on preset maturation periods. Rather matured or substantially matured electric battery cells can be identified and moved to the next stage in production in substantially real time. This again allows to free up space for other cells early on in the production process, which in turn speeds up throughput.

In some embodiments, the maturation process of an electric battery cell is managed using a CMD electrically coupled with the electric battery cell, e.g., to one or more terminals of the electric battery cell. The CMD is operable to measure properties of the electric battery cell undergoing maturation in a controlled environment, using corresponding sensor(s) or a sensor system of the CMD. Such measurements are then evaluated by the CMD, or a remote controller (or control system), to determine whether the electric battery cell has deviated from (e.g., violated) a manufacturing specification for that electric battery cell or complied with (met) the manufacturing specification defining expected progression of the electric battery cell through maturation. The electric battery cell deviating from the manufacturing specification (e.g., a certain property measurement, such as voltage, falls outside a certain predefined threshold, e.g., voltage tolerance) indicates that the electric battery cell is displaying symptoms of a battery cell with a manufacturing fault. The electric battery cell complying with the manufacturing specification (e.g., a certain cell property, such as a voltage rate, falls within a certain predefined threshold, such as voltage rate tolerance) indicates that the electric battery cell has reached (matured to) a state at which the electric battery cell is unlikely to exhibit a manufacturing fault or where the electric battery cell's maturation stage has been substantially completed (the electrochemical processes started during formation have stabilised), so that the electric battery cell can moved to the next stage, e.g., shipping. In either case, i.e., when the electric battery cell deviates from or complies with the manufacturing specification, the electric battery cell can be removed from the controlled environment, thereby freeing up space for a next cell. Also, once the electric battery cell deviates from the manufacturing specification, corresponding measurements and related data can be analysed either by the CMD or by a third party (e.g., a controller) to determine a possible reason for a fault being developed, thus enabling the cell manufacture to correct the production process to prevent further production of similarly faulty cells.

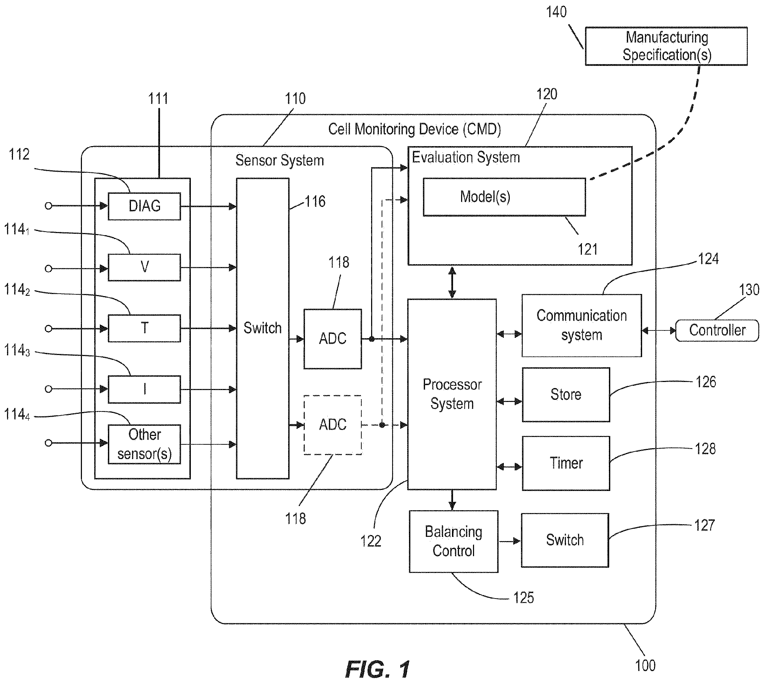

Figure 1 is a schematic illustration of an exemplary arrangement of CMD 100 according to some embodiments. CMD 100 includes sensor system 110, evaluation system 120, processor system 122 (may also be referenced as a processing system), communication system 124, store 126, and timer or clock 128.

To monitor the state of an electric battery cell while it is undergoing maturation, CMD 100 is electrically coupled with such a cell. For example, CMD 100 can be electrically coupled to one or more terminals of the electric battery cell, such as to draw power to support functionality of CMD 100. In some embodiments, CMD 100 is electrically coupled with the cell before the cell is placed into a controlled environment (e.g., control room) to undergo maturation. In some of these embodiments, CMD 100 remains electrically coupled with the cell for the duration of that cell's service or lifetime, i.e., post maturation stage, as defined by a cell manufacturer.

In some embodiments, CMD 100 is electrically coupled with the cell while the cell remains in the controlled environment and decoupled from the cell when the cell is removed from the controlled environment. For example, CMD 100 may be stationed in the controlled environment or as a part of a maturation infrastructure including the controlled environment, for example with other CMDs. In this scenario, CMD 100 may be electrically coupled to the electric battery cell when the electric battery cell is placed into the controlled environment and subsequently uncoupled from the electric battery cell to allow removal for the electric battery cell from the controlled environment, once the electric battery cell matures sufficiently or exhibits a fault. In embodiments where CMD 100 is a part of maturation infrastructure, CMD 100 may be used to monitor the state of multiple electric battery cells in succession, as they are placed in and subsequently removed from the controlled environment. Further, if the maturation infrastructure includes multiple CMDs stationed in the controlled environment, such CMDs may monitor the state of corresponding multiple electric battery cells also stationed in the controlled environment, where each CMD 100 may be used to monitor the state of a plurality of electric battery cells in succession, as they are placed in and subsequently removed from the controlled environment.

In some embodiments, although CMD 100 is electrically coupled to the cell to obtain measurements at the cell, such as voltage, CMD 100 is connected to a separate power supply to support operation of CMD 100. That is, in such embodiments, CMD 100 does not draw power from the electric battery cell to support operation of CMD 100. For example, where CMD 100 is a part of a maturation infrastructure, the maturation infrastructure itself may provide power supply for CMD's operation.

In some embodiments, CMD 100 does not have a separate power supply. Rather, CMD 100 draws power from the electric battery cell, through the electrical coupling with the electric battery cell, to support its operation or functionality as described throughout this disclosure. That is, CMD 100 uses the electric coupling with the electric battery cell to both obtain measurements at the cell and support its operation, such as determining whether the electric battery cell sufficiently matured to be moved to another stage of production or exhibited a fault. Cell manufacturers may configure CMD 100 to draw power from the electric battery cell to operate in order to facilitate on-going monitoring of the electric battery cell's state, including after the electric battery cell leaves the controlled environment, to provide flexibility with the placement of the electric battery cell within the maturation infrastructure, and/or to decrease couplings needed to operate CMD 100.

The power that CMD 100 draws from the electric battery cell to operate is small relative to the expected self-discharge of the cell. Specifically, the power consumption by CMD 100 needed to operate or function as discussed throughout this disclosure is expected to be at least an order of magnitude lower than the expected self-discharge of the corresponding electric battery cell. To decrease the power consumption by CMD 100, in some embodiments, CMD 100 is configured to operate on a duty cycle, whereby the average power draw would become substantially lower than a specified acceptable self-discharge current. As discussed elsewhere in this disclosure, power consumption by CMD 100 can be anticipated, and thus accounted for when conducting evaluation of the corresponding electric battery cell and its state.

CMD 100 can be incorporated with an electric battery cell or attached, permanently or removably, to the electric battery cell or its components. For example, CMD 100 can be configured for attachment to a flexible pouch of a pouch cell or to a housing of the pouch cell.

In some embodiments, CMD 100 is implemented as an application-specific integrated circuit (ASIC). CMD 100 in the form of an ASIC can be configured, e.g., on a printed circuit, to be attached to an electric battery cell or group of cells, such as to a housing or to one or more components of a battery cell or a group of cells, or be incorporated or integrated with a battery cell or a group of cells.

Sensor system 110 measures properties related to the state of an electric battery cell being monitored by CMD 100, such as physical characteristics of the monitored battery cell, electrical characteristics of the monitored battery cell, chemical characteristics of the monitored battery cell, environmental characteristics that influence the state of the cell (e.g., characteristics of the controlled environment), or any combination thereof. Sensor system 110 includes or is connected to a group of sensors 111 related to the monitored electric battery cell and is configured to obtain measurement of different properties of such a cell using sensors 111. Sensor system 110 may also include sensors configured to measure different properties of the cell's environment, such as of the controlled environment. In some embodiments, rather than measuring properties of the cell's environment, CMD 100 receives such measurements from an external source, such as controller 130.

Group of sensors 111 includes one or more voltage sensors 114₁ configured to measure voltage at the monitored cell. Group of sensors 111 may further include one or more temperature sensors 114₂ configured to measure temperature at the monitored cells (e.g., temperature of the monitored cell, temperature of the monitored cell's surface, or temperature of the immediate environment, such as the controlled environment, of the monitored cell). Group of sensors 111 may also include one or more current sensors 114₃ configured to measure current flowing in or out of one or more monitored cells or a group of cells. Group of sensors 111 may include one or more sensors 114₄ configured to measure other properties of one or more monitored cells, for example, one or more pressure sensors, one or more humidity sensors, or a combination thereof.

In some embodiments, CMD 100 may also include balance control circuit 125 with a switch 127 to allow for controlled discharge of the cell, to bring a pack into balance.

Depending on implementation and specific needs of a cell manufacturer, a particular sensor 114 may be positioned: within a cell (e.g., within the cell enclosure, such as within a flexible pouch of a pouch cell), on a cell, its component, or its housing, at a cell, e.g., adjacent, or otherwise proximate to a cell or the respective CMD of the cell, or remotely to a cell, depending on what physical, electrical, chemical, or environmental properties of the cell that sensor 114 is configured to measure.

For example, a pressure sensor in the form of a gas pressure sensor may be integrated within the cell enclosure, to measure gas pressure within the cell enclosure. A pressure sensor in the form of a strain gauge may be positioned on a cell to monitor the deflection of the cell enclosure caused by a change in the internal pressure of the cell. A current sensor may be positioned at a monitored cell to measure current flowing in, out, or through the cell (e.g., electrically coupled to cell terminals to measure their output). A voltage sensor may be positioned at a monitored cell or a group of monitored cells to measure voltage across terminals of the monitored cell or cell group. A temperature sensor may be integrated with CMD 100 to measure temperature of an immediate environment of the cells monitored by CMD 100. Some sensors 114 may be external to both CMD 100 and cells monitored by CMD 100. For example, CMD 100 may employ a temperature sensor for measuring temperature of a surrounding environment.

Each sensor 114 may be implemented as a combination of one or more sensing elements for measuring corresponding physical, electrical, or chemical cell properties and of signal conditioning circuitry that converts the output of the one or more sensing elements into an analogue signal suitable for conversion by analogue-to-digital converter (ADC) 118. The signal conditioning circuitry can be collocated with the one or more sensing elements or located elsewhere in CMD 100, including externally to the respective cell. For example, only sensing elements can be positioned within a cell, on a cell, or at a cell, depending on what physical, electrical, chemical, or environmental properties such sensing elements are configured to measure, while respective signal conditioning circuitry can be positioned externally to the respective cell.

In some embodiments, group of sensors 111 includes one or more external sensors which are integrated with a corresponding ADC. In these embodiments, the ADC provides respective measurements in a digital form. Such measurement can be shared with evaluation system 120 and processor system 122 directly, bypassing ADC 118.

Sensor system 110 may also include self-diagnostic sensors 112 to provide reference measurements. By comparing reference measurements with corresponding measurements obtained by sensors 114 for a given stimulus, CMD 100 is able to determine whether measurements obtained by sensors 114 are true to the actual system operation or distorted, for example, due to internal issues with sensors 114.

Sensor system 110 also includes ADC 118 for converting the measurements obtained by sensors 112 and 114 into a digital form and a switch 116 (e.g., a multiplexer) for directing the measurements from sensors 114 to ADC 118 for conversion. ADC 118 outputs the converted measurements to evaluation system 120, processor system 122, or to both. In some embodiments, switch 116 is integrated into the structure of one or more ADCs 118. For example, ADC 118 may have multiple inputs for receiving sensor measurements.

As shown in Figure 1, CMD 100 may include more than one ADC 118. CMD 100 may employ multiple ADCs 118 to implement parallel processing of measurements acquired by sensor system 110. For example, different ADCs may process measurements of different properties. Such parallel processing enables acquisition and processing of time-synchronised measurements of different properties, e.g., voltage and current, thereby improving efficiency with which the measurements are converted into digital form for processing by evaluation system 120.

Additionally or alternatively, CMD 100 may employ multiple ADC 118 to introduce redundancy within CMD 100. This in turn enhances functional safety of CMD 100, such as in the event of failure by one of ADCs 118.

Evaluation system 120 is operable to evaluate the received measurements to determine whether the cell monitored by CMD 100 has deviated from manufacturing specification 140 for that electric battery cell, while undergoing maturation. Additionally, or alternatively, evaluation system 120 is operable to evaluate the received measurements to determine whether the cell monitored by CMD 100 has progressed successfully through maturation, complying the with the manufacturing specification and a reaching a stage of maturation at which the cell may be moved to the next stage of production. For example, evaluation system 120 may be operable to determine whether the cell has reached a stage of maturation such that the probability of the electric battery cell exhibiting a manufacturing fault while continuing to undergo maturation after reaching that stage is below a certain level. The level can be predetermined and can vary for different cells and/manufacturers, for example, depending on specifics of the production process, applications in which the cell is to be used, type of cell, costs associated with the cell exhibiting a fault, costs associated with continuing maturation of the cell in the controlled environment, and/or other considerations.

Evaluation system 120 employs model(s) 121 (also referenced as cell model(s)) to evaluate the received measurements. Evaluation system 120 may have one or more model(s) 121 defined for the monitored electric battery cell according to manufacturing specification 140 of that electric battery cell. Model(s) 121 may comprise one or more functions dependent on one or more properties of the cell (e.g., voltage-dependent functions) and/or of the controlled environment to enable evaluation system 120 to evaluate whether the cell matures as-expected, has deviated from manufacturing specification 140, or reached a predetermined stage of maturation when the cell can be moved to next stage of production.

In some embodiments, evaluation system 120 is implemented in digital logic on an ASIC forming CMD 100. In such implementations, functionality of evaluation system 120 and cell model(s) 121 are defined at the ASIC design stage.

In some embodiments, evaluation system 120 is implemented as a processor separate from processor system 122 with separate memory (not shown) and processing defined by firmware. In this implementation, evaluation system 120 may take the form of a microprocessor or an embedded processor. When evaluation system 120 is implemented as a separate processor, CMD 100 can be adapted to work with specific cells, or a type of cells post-design and post-manufacturing. No knowledge of cell's chemistry or type is required during design or manufacturing of CMD 100 to ensure full functionality of evaluation system 120.

Additionally, or alternatively, evaluation system 120 can be reprogrammed after being assembled with the electric battery cell, for example, to modify one or more of the model(s), for example, according to updated manufacturing specification(s) 140, or upload new model(s) 121 defined according to new or updated manufacturing specification(s) 140, and/or to modify settings in cell model(s) 121, update cell model(s) 121, or upload new cell model(s) 121.

Thus, CMD 100 may be used to monitor multiple electric battery cells successively, including electric battery cells of different types or chemistry, without necessarily having advanced knowledge of what type or chemistry CMD 100 would monitor. Rather, appropriate model(s) 121 defined according to manufacturing specification(s) 140 of a particular electric battery cell to be monitored by CMD 100 can be uploaded or updated once that cell is electrically coupled with CMD 100. For example, CMD 100 may be included into a maturation infrastructure for hosting cells during the maturation stage (rather than in a cell itself) and be reprogrammed (e.g., model(s) 121 updated with new parameters or new model(s) uploaded) when an electric battery cell of a different cell type is placed into the maturation infrastructure and coupled with CMD 100.

Further, manufacturing specification(s) 140, and thus cell model(s) 121, may be updated as CMD 100 observes maturation by electric battery cells of a particular type. For example, specific parameters, such as thresholds or tolerances used by one or more model(s) 121 can be refined as a cell manufacturer refines parameters in corresponding manufacturing specification(s) 140, for example, based on analysis of data concerning maturation processes of cells of a particular type over time.

In some embodiments, a combination of hardware and software is used to implement evaluation system 120. In such implementations, evaluation system's processes can be designed using digital logic of an ASIC forming CMD 100, while parameters that would be employed by model(s) 121 can be programmed into locally stored tables. This programming can be implemented using different methods. For example, during the production stage or prior to CMD 100 being used with a particular cell, a metal layer mask made for that cell's chemistry can be introduced into CMD 100 to configure CMD 100 to work with the cell. Another example is to introduce one-time programmable memory (e.g., poly fuses) into CMD 100 during the production stage and program such memory with relevant tables prior to using CMD 100 with a cell. Yet another example is to load chemistry specific tables by processor system 122.

Although Figure 1 shows evaluation system 120 as a separate component, in some embodiments, evaluation system 120 is integrated with processor system 122.

Evaluation system 120 receives one or more measurements related to the monitored electric battery cell as input and evaluates such measurements using one or more models 121, defined according to manufacturing specification 140 of the monitored cell, to determine whether the electric battery cell, as it undergoes maturation, has deviated from manufacturing specification 140 (e.g., developed a manufacturing fault), or complied with manufacturing specification 140, reaching a predetermined stage of maturation when the cell can be moved to a next stage of production (e.g., a state in which the electrochemical processes started during cell formation have stabilised and the cell is not likely to develop or exhibit a manufacturing fault). For example, the predetermined stage of maturation can be defined as a state of maturation of the electric battery cell in which the probability of the electric battery cell exhibiting a manufacturing fault while continuing to undergo maturation is below a predetermined level, which could be based on a level of confidence sought by a cell manufacturer of whether the electric battery cell is likely to develop or exhibit a manufacturing fault thereafter.

Evaluation system 120 evaluates received measurements using model(s) 121 to determine whether the cell has deviated from manufacturing specification 140, or successfully reached a stage of maturation when it can be removed from the controlled environment, and outputs results of the evaluation. In some embodiments, a determination that the cell has not deviated from manufacturing specification 140 indicates that maturation process is ongoing as expected. Evaluation system 120 continues with analysis of subsequent measurements obtained at the cell to monitor maturation of the cell until the cell reaches the stage when it can be removed from the controlled environment due to successful progression of maturation or because it exhibited a manufacturing fault.

Model(s) 121 may comprise one or more functions defined for or dependent on one or more properties of the cell monitored by CMD 100 and/or one or more properties of the controlled environment, in accordance with manufacturing specification 140 of the monitored cell. More than one function may be defined for a single cell property. A single function may be defined for multiple properties of the cell, or combination properties of the cell and controlled environment. Model(s) 121 defined for the cell according to manufacturing specification 140 can be simple and/or complex evaluation models, including but not limited to numerical model(s), analytical model(s), empirical model(s), or any combination thereof.

A simple model defined according to manufacturing specification 140 may include functions that define limits (or thresholds, or tolerances) against which cell's property measurements are checked to determine whether manufacturing specification 140 has been complied with or deviated from, e.g., whether the one or more measurements exceed one or more of the predefined limits, e.g., higher or below the one of the predefined limits, or outside predefined limits, or within predefined limits. A more complex cell model may include function(s) modelling anticipated changes in one or more measurement over time, and/or set a varying threshold (tolerance) for one or more cell properties (e.g., voltage) based on a measurement of another one or more cell properties (e.g., temperature).

Functions included in model(s) 121 may define one or more of, or any combination thereof: expected behaviour, changes, and/or benchmarks of respective one or more properties of a good functional cell as it progresses through maturation; expected behaviour, changes, and/or benchmarks of respective properties of a good functional cell that has reached a state at which the cell is unlikely to develop or exhibit a manufacturing fault, as for example, determined by the manufacturer based on prior testing of the same type of cells; and/or behaviour, changes, and/or benchmarks of respective properties indicative that a cell exhibited a manufacturing fault as it progresses through maturation. A function can define changes in a particular property over time. A function may include tolerance(s) defining acceptable deviations from the defined function that do not raise to a level of the cell exhibiting a manufacturing fault. A function may set one or more thresholds crossing of which is indicative of the cell exhibiting a manufacturing fault.

Different models 121 may correspond to different manufacturing specifications 140 and may be operable to evaluate respectively states of different types of cells according to such manufacturing specifications. Additionally or alternatively, evaluation system 120 may employ one or more models 121 each operable to evaluate different cell properties or different combinations of cell properties for the same monitored cell. In the latter scenario, property measurements of the cell may need to be evaluated against all such models before evaluation system 120 is able to determine whether the cell successfully reached a predetermined stage of maturation when it can be removed from the controlled environment, while evaluation of property measurement of the cell against one of such models may result in determination that the cell deviated from manufacturing specification 140.

In some embodiments, one or more cell models 121 may be adapted or introduced to facilitate identification of a cause or type of manufacturing fault(s) exhibited by the cell. For example, once evaluation system 120 determines that the monitored cell deviated from manufacturing specification 140, evaluation system 120 may employ such one or more cell models 123 to detect a cause or a type of a manufacturing fault that resulted in the cell deviating from manufacturing specification 140. One or more cell models receive cell's property measurements gathered by CMD 100 as input, evaluate such measurements using parameter(s) (e.g., thresholds or tolerances) and/or simple or complex evaluation models (e.g., numerical model(s), analytical model(s), empirical model(s), or any combination thereof) to determine a possible manufacturing fault, and output results of the evaluation.

One or more cell models 121 may include one or more numerical cell models, one or more analytical cell models, one or more empirical models, or any combination thereof. One or more cell models 121 may include one or more simple models, one or more complex models, or a combination of both. A simple cell model may check inputted one or more measurements against one or more predefined limits (or thresholds) and flag a fault when the one or more measurements exceed one or more of the predefined limits, e.g., higher or below the one of the predefined limits, or outside predefined limits, or within predefined limits. A more complex cell model may first process the one or more measurements, e.g., by determining one or more derivative measurements and comparing such derivative measurements to one or more thresholds (predefined limits), and then apply filter(s), algorithm(s), or both to determine a fault. A more complex model may also, or instead, set a varying threshold for one or more cell properties (e.g., voltage) based on a measurement of another one or more cell properties (e.g., temperature), as well as or instead define expected changes in the one or more cell properties over time during a maturation stage.

Manufacturing specification(s) 140 and cell model(s) 121 may be implemented using software, firmware, hardware, or mixture of thereof. For example, checks against thresholds or limits may be implemented in hardware, using analogue or digital comparators, while the threshold or limits themselves may be set and varied by software or firmware. Another example is a manufacturing specification or cell model designed to integrate the signal from a current sensor over time to provide a coulomb (Amp-seconds) count. The signal integration may be implemented in digital hardware, e.g., using a digital integrator, or in software, e.g., using processor's arithmetical capability.

CMD 100 may implement various levels of self-testing and self-diagnostic to identify system faults. These include, but are not limited to, ADC operational checks, analogue multiplexer (MUX) operational checks, error correction circuitry on random-access memory (RAM) and flash memory, stack overflow detection, Cyclic Redundancy Check (CRC) in message packets, open circuit detection, watchdog to reset system in event of lock up or run-away operation, identification of communications failure between sub element of CMD 100, or any combination thereof.

Processor system 122 generally controls operation of CMD 100 and its communication with third parties, such a central controller, or an external device or an external system, e.g., BMS (not shown). Processor system 122 includes at least firmware for executing CPU, RAM, and clocks.

In some embodiments, processor system 122 takes the form of a microcontroller. Additionally or alternatively, processor system 122 may include a microprocessor, a digital signal processor (DSP), an embedded processor, or the like, or may be integrated in a system on a chip (SoC). In some embodiments, processor system 122 includes a processor from the family of processors manufactured by Intel^{®}, AMD^{®}, Qualcomm^{®}, Apple^{®}, NVIDIA^{®}, or the like. Processor system 122 may also be based on the ARM architecture, a mobile processor, etc.

In some embodiments, processor system 122 may be powered down when not in use. Processor system 122 may then be restarted with a signal received from evaluation system 120, communication system 124, or timer or clock 128.

Communication system 124 enables communication by processor system 122 with external parties, such as a central controller or an external device or system. In some embodiments, communication system 124 includes one or more components for enabling communication between CMD 100 and external devices or systems, such as a transceiver, a receiver, a transmitter, or combination thereof. Communication system 124 may support wireless communications, for example, using Bluetooth^{®} or Near Field Communication (NFC) protocols. Alternatively or additionally, communication system 124 may support a wired connection with a controller e.g., USB, CANbus, parallel bus, or another type of wired connection suitable for purpose.

Processor system 122 uses communication system 124 to share the status of the monitored cells with external systems, such as a controller. For example, CMD 100 may issue an alert for removal of a monitored cell when CMD 100 determines that the monitored cell complied with or deviated from (met or violated respectively) its manufacturing specification. CMD 100 may also share results of fault determination upon evaluation system 120 completing evaluation of measurements once a determination is made that the monitored cell deviated from manufacturing specification 140.

In some embodiments, CMD 100 time-shifts, e.g., delays, its communication of a status of the monitored cell, including the status of the monitored cell, including any detected faults and related fault data. For example, rather than sharing results, once evaluation system 120 determines that the monitored cell has complied with or deviated from manufacturing specification 140, CMD 100 delays communicating the results until a pre-scheduled time or until CMD 100 receives a corresponding request from an external device or system.

To enable such time-shifting, processor system 122 stores data concerning the status of monitored cells, possibly any faults that evaluation system 120 detects, and related measurements at store 126 for subsequent retrieval along with timing information indicating when, if any, respective faults were detected or measurements collected. Processor system 122 is then able to retrieve relevant data from store 126 and share the retrieved data through communication system 124 with a third party, such as a controller or an external system or device, for example, for subsequent analysis.

Store 126 is memory that includes one or more storage devices for storing measurements CMD 100 gathers at the monitored cell monitored and related data, such as results of evaluation by evaluation system 120. The one or more storage devices may include, but are not limited to, flash memory (e.g., NOR flash or NAND flash), static random-access memory (SRAM), dynamic random-access memory (DRAM), ferroelectric random-access memory (FRAM), erasable programmable read-on memory (EPROM), electrically erasable programmable read-on memory (EEPROM), nonvolatile random-access memory (NVRAM), and/or any other suitable storage device.

Data stored at store 126 to capture the state of cells monitored by CMD 100 over time (may be referenced in this disclosure as cell state data) includes a state indicator, indicating whether the monitored cell has complied with or deviated from its manufacturing specification, and related data, such as a timestamp of when CMD 100 detected the state change and measurements that resulted in the state change. Cell state data may also include measurements taken at the monitored cells when no state change was detected, derivatives of such measurements, or both, along with information indicating timing of when the measurements were received by evaluation system 120 or processor system 122 from sensor system 110.

In some embodiments, the state indicator takes the form of flag(s) or designated bit (e.g., "0" or "1" designated bit) to indicate that CMD 100 complied with manufacturing specification 140 or deviated from manufacturing specification 140.

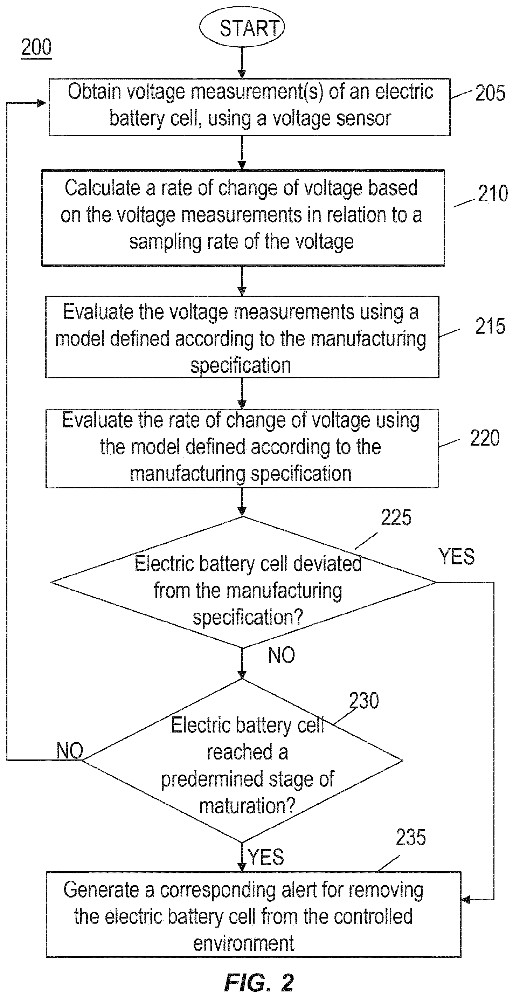

Figure 2 depicts method 200 for monitoring or managing a maturation stage of an electric battery cell, according to some embodiments. Method 200 may be performed by CMD 100 electrically coupled to the electric battery cell, while the electric battery cell is undergoing maturation in a controlled environment, after being charged.

For an electric battery cell maturing as expected (i.e., according to a corresponding manufacturing specification), the voltage of that electric battery cell, first, decreases immediately following cell formation (at the beginning of the maturation stage), then, plateaus after a time period, and then, remains stable. Thus, a rate of change of voltage being proximate to zero, i.e., *dV*/*dt ≅* 0, after that time period, is indicative of a good functional cell, with a low rate of self-discharge. However, the cell voltage continuing to decrease instead of plateauing, or the rate of change of voltage failing to approach zero after that period of time are indicative of a high self-discharge rate, and thus of an electric battery cell experiencing a manufacturing fault. A high self-discharge rate could be the result of, but not limited to, an internal resistance increase, an improper SEI formation, electrolyte underfill or overfill, or leakage, or an internal short circuit.

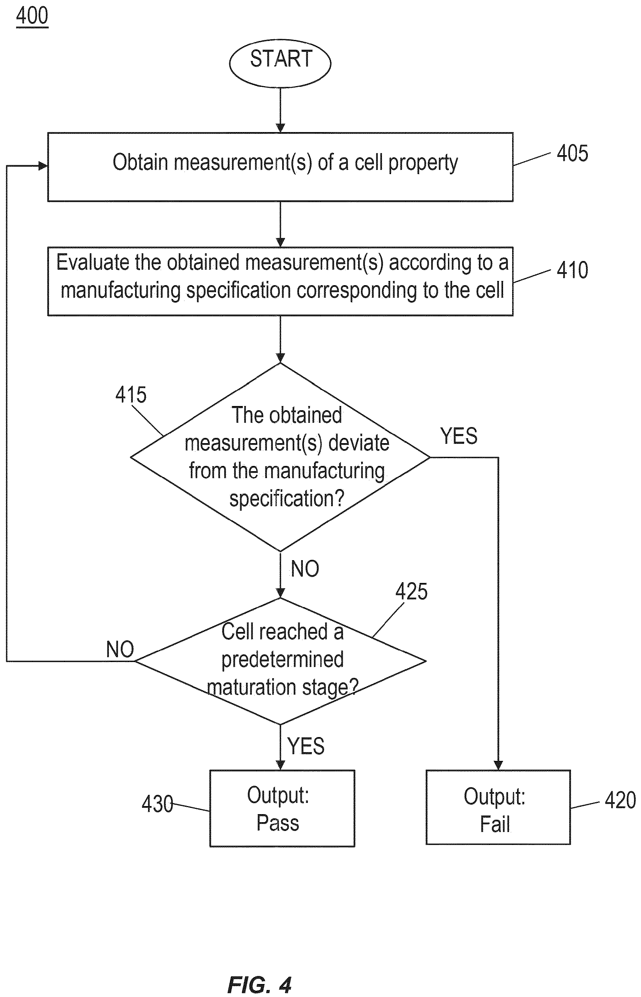

Method 200, as described, uses the voltage changes expected during the maturation stage as the basis for monitoring or managing the maturation stage of an electric battery cell. Although method 200 is described as relying solely on voltage measurements for monitoring or managing the maturation stage of the electric battery cell, another one or more cell properties may be measured and used to monitor or manage the maturation stage of an electric battery cell, in addition to the voltage measurements. These are described elsewhere in this document, for example with reference to Figures 4-10.

Method 200 starts with step 205, at which CMD 100 obtains one or more voltage measurements of the electric battery cell. CMD 100 may, for example, use a voltage sensor 114₁ to measure voltage of the electric battery cell.

At step 210, CMD 100 calculates a rate of change of voltage based on the obtained voltage measurements, relative to the sampling rate with which the voltage has been measured. For example, CMD 100 may use last two or more sequential voltage measurements to determine the rate of change.

At step 215, CMD 100 compares the voltage measurements of the electric battery cell to a voltage tolerance predefined for the electric battery cell by manufacturing specification 140. For example, manufacturing specification 140 may define the voltage tolerance as the minimum voltage that the electric battery cell may reach through discharge during the maturation stage. The electric battery cell discharging below that minimum voltage during the maturation stage would mean that the electric battery cell deviated from (violated) the manufacturing specification, and thus is considered to exhibit a manufacturing fault.

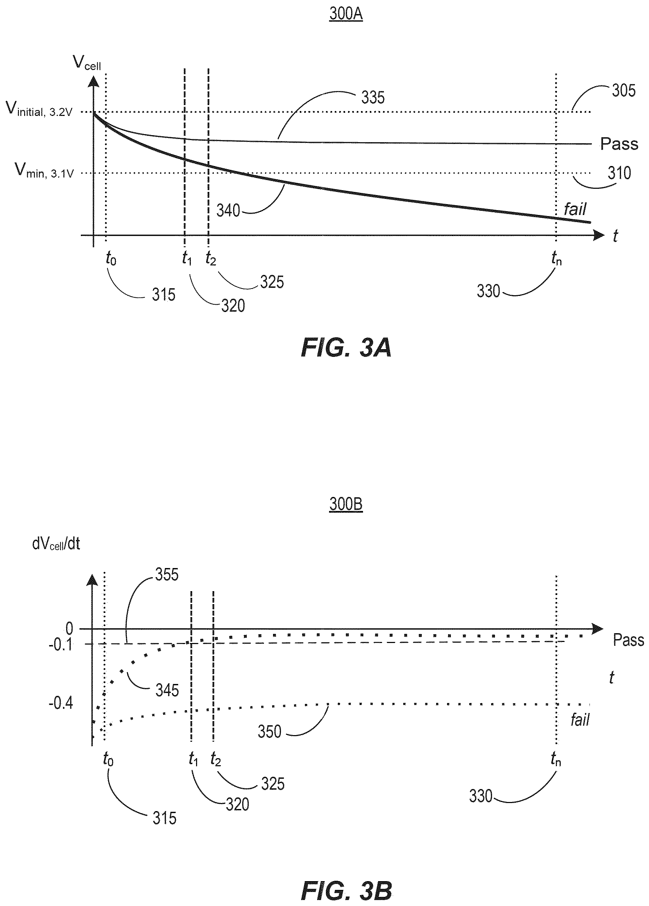

For example, with reference to Figure 3A, this figure depicts two voltage-dependent functions, i.e., functions 335 and 340 of voltage over time corresponding respectively to two electric battery cells *A* and *B* of the same type and undergoing maturation. Both electric battery cells *A* and *B* have the same starting voltage point, i.e., during the formation stage, they have been charged to initial voltage 305 of 3.2V.

Following the formation stage, at the beginning of the maturation stage, i.e., time period [*t₀, t₁*], voltage of both electric battery cells *A* and *B* has decreased. As reflected by functions 340 and 335 respectively, voltage of electric battery cell B decreased more drastically than voltage of electric battery cell *A* over the same time period. However, since neither electric battery cell *A* nor electric battery cell B has had its voltage dip below minimum threshold or tolerance 310 of 3.1V during time period [*t*₀*, t₁],* neither electric battery cell has yet deviated from the manufacturing specification.

Over next time period of [*t₁, t₂*] of the maturation stage, voltage of electric battery cell *A* has plateaued (as reflected by function 335), while voltage of electric battery cell B has continued to decrease (as reflected by function 340). However, as neither electric battery cell A nor electric battery cell *B* has its voltage dip below minimum threshold or tolerance 310 during time period [*t₁, t₂*], neither electric battery cell has yet deviated from the manufacturing specification.

Then, over time period [*t₂, tₙ*] of the maturation stage, the voltage of electric battery cell *A* has remained stable (as reflected by function 335), while the voltage of electric battery cell B has continued to decrease further (as reflected by function 340) eventually dipping below minimum tolerance or threshold 310. Thus, while electric battery cell A has matured as expected over the entire time period [*t₀, tₙ*], thereby resulting in a cell that complies with the manufacturing specification, electric battery cell B has not matured as expected, eventually crossing minimum voltage threshold 310 during time period [*t₂, tₙ*], and thus deviating from the manufacturing specification. This indicates that electric battery cell B exhibited a manufacturing fault and is not suitable for its intended use.

Returning to Figure 2, in some embodiments, the voltage tolerance or threshold used at step 215, such as minimum voltage 310, is time-dependent and changes as the electric battery cell progresses through the maturation stage. In these embodiments, the manufacturing specification may define the voltage tolerance as a function over time, such as a continuous function, a selection of specific values corresponding to different points in time, ranges, and the like. That is, the voltage measurements of the electric battery cell can be compared to a different value of the voltage tolerance or threshold, depending on how far the electric battery cell is into the maturation stage.

Additionally, or alternatively, the voltage tolerance or threshold used at step 215 may depend on environmental characteristics, such as a temperature and/or humidity of the controlled environment in which the electric battery cell is undergoing maturation.

At step 220, CMD 100 compares the calculated rate of change of voltage to a rate of change tolerance predefined for the electric battery cell by manufacturing specification 140. For example, manufacturing specification 140 may define the rate of change tolerance or threshold as one or more of the maximum rate of change of voltage that the electric battery cell may experience through discharge at the beginning of the maturation period, the maximum rate of change of voltage that the electric battery cell may experience through discharge while voltage of the electric battery cell plateaus, or the maximum rate of change of voltage that the electric battery cell may experience through discharge once voltage of the electric battery cell stabilises. The electric battery cell experiencing a rate of change of voltage that exceeds such a rate of change tolerance at a corresponding time during the maturation stage may then be indicative of that the electric battery cell deviating from the manufacturing specification, and thus exhibiting a manufacturing fault.

For example, with reference to Figure 3B, this figure depicts two voltage-dependent functions, i.e., functions 345 and 350 of a rate of change of voltage over time corresponding respectively to electric battery cells *A* and *B* discussed with reference to Figure 3A.

As discussed with reference to Figure 3A, following the formation stage, at the beginning of the maturation stage, i.e., time period [*t*₀*, t*₁], voltage of both electric battery cells *A* and *B* has decreased, where voltage of electric battery cell B decreased more drastically than voltage of electric battery cell A. This is reflected by functions 350 and 345 respectively, which show that the rate of change of voltage of electric battery cell *B* has not changed significantly over time period [*t₀, t₁*], remaining at below -0.4 (function 350), while the rate of change of voltage of electric battery cell *A* has decreased (function 345) over time period [*t₀, t₁*], from about -0.4 to about -0.1.

Over next time period of [*t*₁, *t₂*], the rate of change of voltage of both electric battery cells *A* and *B* has stabilised. However, while the rate of change of voltage of electric battery cell *A* is close to and approaches zero (between -0.1 and 0), the rate of change of voltage of electric battery cell B has remained substantial, at about -0.4. These correspond to voltage of electric battery cells A plateauing and voltage of electric battery cells B continuing to decrease over same time period as shown in Figure 3A.

Finally, over time period [*t₂, tₙ*], the rate of change of voltage for both electric battery cells *A* and *B* has remained stable. The rate of change of voltage of electric battery cell *A* is close to zero. This corresponds to voltage of electric battery cell A remaining stable over the same time period, as shown in Figure 3A. Thus, electric battery cell *A* has matured as expected, over the entire time period [*t_{0,} tₙ*], thereby resulting in a cell that complies with the manufacturing specification.

In contrast, although the rate of change of voltage of electric battery cell *B* has remained stable, it has never reached or approached zero, but rather remained stably high. This corresponds to voltage of electric battery cell B continuing to decrease over the same time period, as shown in Figure 3A. This means that electric battery cell B has exhibited a high rate of self-discharge, deviating from or violating the manufacturing specification, which in turn indicates that electric battery cell *B* is not suitable for its intended use.

Returning to Figure 2, in some embodiments, the rate of change tolerance or threshold defined by manufacturing specification 140 is time-dependent and changes as the electric battery cell progresses through the maturation stage. That is, at step 220, the rate of change of voltage calculated based on voltage measurements of the electric battery cell can be compared to a different rate of change tolerance or threshold depending on how far the electric battery cell is into the maturation stage. In some embodiments, manufacturing specification 140 defines the rate of change tolerance for after voltage of electric battery cell stabilises. In some embodiments, manufacturing specification 140 may define a time-dependant rate of change tolerance for the entire maturation process, e.g.., a high rate of change would be acceptable immediately after formation, where the voltage of the cell is expected to decay fast, while as the cell would progress through maturation, the rate of change tolerance would reduce.

Based on comparison results of steps 215 and 220, CMD 100 determines if the electric battery cell complied with or deviated from manufacturing specification 140. For example, if voltage of the electric battery cell is above the voltage tolerance (*V_{cell} > Vₘᵢₙ*) and the rate of change of voltage is proximate to zero (*dV*/*dt* ≅ 0), CMD 100 may determine that the electric battery cell has met manufacturing specification 140, and thus the electric battery cell reached the stage after which it is unlikely to develop a manufacturing fault. This scenario has been, for example, described with reference to Figures 3A and 3B, concerning electric battery cell *A* at time period [*t₂, tₙ*]. If voltage of the electric battery cell is above the voltage tolerance *(V_{cell}* > *Vₘᵢₙ*), but the rate of change of voltage is above zero (*dV*/*dt > 0*), CMD 100 may determine that the electric battery cell has not yet met manufacturing specification 140 and continues to undergo maturation. This scenario has been, for example, described with reference to Figures 3A and 3B, concerning electric battery cells *A* and *B* at time period [*t*₀*, t₂*]. If voltage of the electric battery cell is below the voltage tolerance (*V_{cell} < Vₘᵢₙ*), CMD 100 may determine that the electric battery cell deviated from manufacturing specification 140. This scenario has been, for example, described with reference to Figures 3A and 3B, concerning electric battery cell *B* at time period [*t₂, tₙ*].

If the comparisons results indicate that the electric battery cell neither complied with manufacturing specification 140 (step 225), nor deviated from manufacturing specification 140 (step 230), method 200 returns to step 205, for CMD 205 to obtain further one or more voltage measurements of the electric battery cell. In this manner, method 200 repeats steps 205 to 230 for the electric battery cell in the controlled environment, until CMD 100 determines that the electric battery cell has complied with or deviated from manufacturing specification 140 predefined for the electric battery cell.

In some embodiments, the loop of steps 205 to 230 is repeated at regular time intervals, e.g., every second, or every few seconds. In some embodiments, the loop of steps 205 to 230 is repeated at regular measurement increments, e.g., each 0.1 mV.

If the comparison results of steps 215 and 220 indicate that the electric battery cell complied with manufacturing specification 140 (step 225) or deviated from manufacturing specification 140 (step 230), method 200 proceeds to step 235, at which CMD 100 generates a corresponding alert, such as an alert for removing the electric battery cell from the controlled environment. For example, CMD 100 may send a corresponding signal, e.g., a signal containing the alert, to a central controller (e.g., controller 130), collecting such data from a plurality of CMDs 100 monitoring corresponding electric battery cells. The signal may indicate whether the electric battery cell complied with or deviated from manufacturing specification 140. In some embodiments, the alert may be accompanied by corresponding voltage measurements and voltage rate calculations. Such data may allow the controller or other party to adjust manufacturing specification 140 for use with electric battery cells of the same type, or to narrow or identify a cause of a manufacturing fault manifested in the electric battery cell, and prevent further manufacture of faulty cells. In some embodiments, if CMD 100 is configured to determine a manufacturing fault upon determining that the electric battery cell deviated from or violated manufacturing specification, the alert may be accompanied by data identifying or describing the manufacturing fault identified by CMD 100.

The order of steps 210 to 230 shown in Figure 2 is not fixed and may vary. For example, step 215 may precede step 210, or be performed after step 220 or in parallel with one or more of steps 210 and 220; step 230 may precede step 225 and/or step 220, and so on. As a further example, steps 220 and 225 may be combined into a single step. Similarly, steps 215 and 230 and/or steps 220 and 230 may be combined into a single step.

Although method 200 of Figure 2 is described as relying solely on voltage measurements to monitor or manage the maturation stage of an electric battery cell, one or more other cell properties may be measured (or determined) and employed in addition to voltage measurements. Figure 4 depicts process 400 for employing within a method for monitoring or managing the maturation stage of an electric battery cell, such as method 200. Specifically, process 400 provides for monitoring of a cell property in addition to cell voltage. Multiple processes 400 may be employed within a method for monitoring or managing the maturation stage of an electric battery cell for monitoring different cell properties respectively. Cell properties that could be used in addition to cell voltage in order to monitor and/or manage the maturation stage include, but are not limited to, one or more of: internal resistance, temperature, pressure, strain or stress, or weight of the cell.

Process 400 starts with step 405, at which CMD 100 obtains one or more measurements of a cell property of an electric battery cell. CMD 100 may, for example, use a corresponding sensor of group of sensors 111, such as temperature sensor 114₂, current sensor 114₃, or another sensor 114₄.

At step 410, CMD 100 evaluates the obtained measurement(s) according to a manufacturing specification corresponding to the electric battery cell. Specifically, CMD 100 may evaluate the obtained measurement relative to respective one or more tolerance(s) defined by the manufacturing specification of the cell. In some embodiments, the obtained measurement(s) may be compared directly to one or more corresponding tolerance thresholds. In some embodiments the obtained measurements are processed prior to being compared to one or more corresponding tolerance thresholds. For example, two or more measurements could be processed to determine a rate of change of the cell property, which then can be compared to one or more corresponding tolerance thresholds. The measurements could be consecutive, or selected to be spaced apart by a particular time interval, notwithstanding whether additional measurements are taken during such time intervals. In some embodiments, the measurements of the cell property are plotted over time and compared with one or more corresponding tolerance plots and/or a model defining behaviour of the cell property during the maturation stage when the cell matures as expected.

If at step 415 it is determined that the obtained measurement(s) fail to comply with the tolerance(s) set by the manufacturing specification, e.g., exceed a particular tolerance value, the process continues with step 420 at which a determination is made that the cell failed to comply with or meet its manufacturing specification. At step 420, data related to the determined failure is output by process 400. For example, such data can be saved internally, in CMD's memory, output within the method for monitoring or managing the maturation stage, and/or shared with an external entity.

If at step 415 it is determined that the obtained measurement(s) comply with the tolerance(s) set by the manufacturing specification, e.g., do not exceed the respective tolerance(s), the process continues to step 425 to determine whether the cell sufficiently matured so as to be moved to the next stage of manufacture or otherwise reached a certain predefined stage, such as described with reference to method 200. If the cell has matured sufficiently to be moved to the next stage of manufacture, process 400 continues to step 430. At step 430, a determination is made that the cell passed its manufacturing specification according to the evaluated cell property and corresponding data is output by process 400. For example, such data can be saved internally, in CMD's memory, output within the method for monitoring or managing the maturation stage, and/or shared with an external entity. If the cell has not yet reached the predefined maturation stage, process 400 returns to step 405 to obtain further measurements of the cell property.

Process 400 may be employed to monitor or evaluate different properties of an electric battery cell. These include but are not limited internal resistance, temperature, pressure, strain or stress, and weight of the cell. Non-limiting examples of how these cell properties can be used to determine whether an electric battery cell has failed or passed the maturation stage using process 400 are now discussed in turn.

### Temperature

When an electric battery cell matures as expected, such as according to its manufacturing specification, the temperature of the cell should not vary from the temperature of the controlled environment in which the cell is undergoing maturation outside an acceptable tolerance. The temperature of the controlled environment may be varied during the maturation period, for example to accelerate stabilization of electrochemical processes within the cell started during its formation. When the temperature of the controlled environment changes, the temperature of the cell should similarly change. An acceptable tolerance for variations between the temperatures of the controlled environment and of the cell would typically be specified in a corresponding manufacturing specification. An acceptable tolerance may vary as the cell progresses through maturation, depending on the temperature of the controlled environment, or on whether the temperature of the controlled environment is undergoing a change. Variations of the cell temperature from the temperature of the controlled environment outside the acceptable tolerance could indicate a short circuit in the cell.

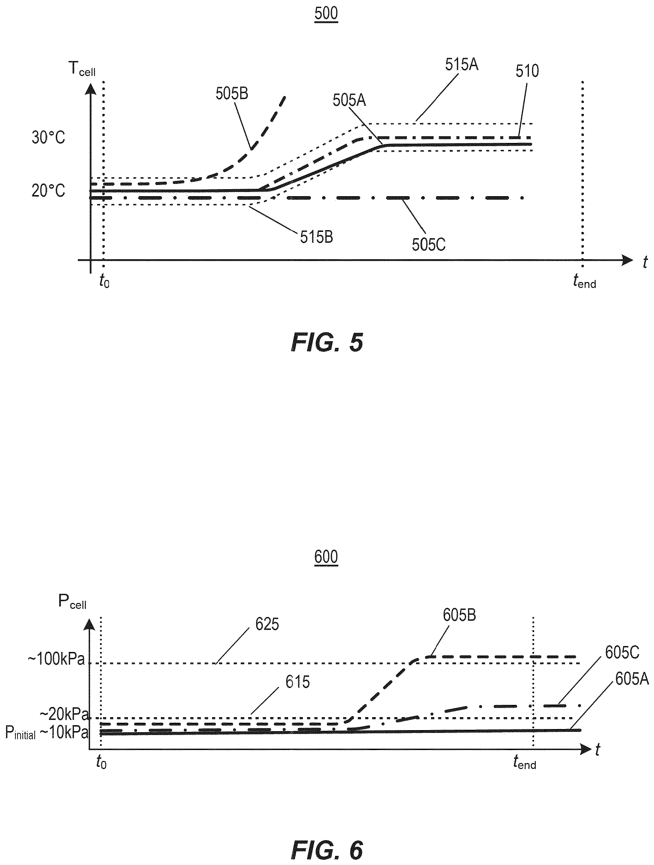

For example, with reference to Figure 5, this figure depicts three functions of temperature over time, functions 505A, 505B, and 505C, corresponding respectively to three electric battery cells A, B, and C of the same type and undergoing maturation over time period [*t₀, t_{end}*]. Function 510 represents the temperature of the controlled environment in which cells A, B, and C are undergoing maturation, while functions 515A and 515B represent boundaries of the accepted tolerance for temperature variations. Although Figure 6 depicts that the acceptable tolerance does not change in relation to the temperature of the controlled environment, in some embodiments the acceptable tolerance may change. For example, as the cell matures, the acceptable tolerance may decrease (e.g., functions 515A and 515B would be closer to function 510 as time progresses toward *t_{end}*), and/or increase when the temperature of the controlled environment changes (e.g., functions 515A and 515B would be further apart where function 510 reflects change of the temperature from 20 degrees to 30 degrees). Additionally or instead, a delta between tolerance function 515A and controlled environment temperature function 510 may differ from a delta between tolerance function 515B and controlled environment temperature function 510 for the same point in time, such as a greater tolerance may allowed for the cell temperature being below the controlled environment temperature than for the cell temperature being above the controlled environment temperature, or vice versa.

As shown in Figure 6, all electric battery cells A, B, C had approximately the same temperature at time *t*₀*,* as the temperature of the controlled environment, i.e., about 20 degrees. As electric battery cells A, B, C underwent maturation, their respective temperatures started to vary from the temperature of the controlled environment in different ways. For example, the temperature of cell A represented by function 505A, generally followed the temperature of the controlled environment represented by function 510 and remained within the accepted tolerance defined and depicted by functions 515A and 515B. The temperature of cell A varied from the temperature of the controlled environment to a greater extent when the temperature of the controlled environment changed than when the temperature of the controlled environment was constant, i.e., when the temperature of the controlled environment changed from 20 degrees to 30 degrees vs maintained at 20 or 30 degrees. However, as the temperature of cell A remained within the acceptable tolerance over the entire maturation time period [*t₀*, *t_{end}*], cell A is considered to pass the maturation stage based on the temperature analysis.

Concerning cell B, the temperature of cell B depicted by function 505B started by generally following the temperature of the controlled environment depicted by function 510, but soon thereafter exceeded the accepted tolerance defined and depicted by function 515B, and then continued to increase. Such changes in the temperature of cell B are indicative of a short circuit created within the cell, which resulted in heat being generated at the cell. This kind of cell behaviour has the potential to be catastrophic, e.g., it may result in the cell entering a thermal runaway state, the impact of which would be hazardous and costly. Thus, cell B is considered to fail the maturation stage based on the temperature analysis.

Concerning cell C, the temperature of cell C depicted by function 505C started by generally following the temperature of the controlled environment depicted by function 510. However, while the temperature of the controlled environment increased from 20 degrees to 30 degrees approximately halfway into time period [*t*₀*, t_{end}*], the temperature of cell C remained constant at about 20 degrees. Such an offset in the cell temperature readings could indicate an issue with the control environment or an issue with an internal temperature sensor of cell C. In this scenario, cell C may also be considered to fail the maturation stage based on the temperature analysis.

Temperature and tolerance values depicted in Figure 6 are merely exemplary. Actual values may vary depending on chemistry, format, or a state of a particular cell, a desired progression of or timeline for the maturation stage, implementation details or limitations, and the like. All or some of these parameters may be defined by a corresponding manufacturing specification.

Returning to process 400 of Figure 4, when such process is applied to evaluate cell's temperature, CMD 100 obtains measurement(s) of cell's temperature at step 405. Also at step 405, CMD 100 may receive data indicative of controlled environment's temperature. For example, CMD 100 may receive actual measurements of controlled environment temperature corresponding in time to cell temperature measurements obtained by CMD 100. In some embodiments, CMD 100 may instead be provided with data defining temperature and its changes (e.g., as a function of time) during the maturation period as set to control temperature of the controlled environment. Such data may be set and shared with CMD 100 before starting the maturation stage or updated as the maturation stage progresses.

CMD 100 may also receive tolerance data, unless previously provided, or updates to previously received tolerance data. In some embodiments, tolerance data is provided for the duration of the maturation stage. In some embodiments, tolerance data may be updated depending on temperature analysis as the cell progresses through maturation. Yet in some embodiments, the tolerance data may be updated depending on temperature analysis during maturation of other cells of the same type and/or undergoing maturation in the same controlled environment.

At step 410, CMD 100 evaluates the temperature measured at the cell by comparing the measured temperature to the temperature of the controlled environment (e.g., measured or predetermined) using corresponding tolerance value(s). If at step 415 the variance of measurement(s) of the cell temperature from the corresponding value(s) of the controlled room temperature (e.g., the absolute difference) exceeds a respective tolerance (e.g., a set value), then process 400 continues to step 420 at which a determination is made that the cell has failed its manufacturing specification during the maturation stage. The set tolerance(s) may depend on the thermal inertia of the cell being matured. For example, the temperature of a larger electric battery cell with a lot of material would lag the temperature rise/fall of the controlled environment to a greater extent than a small cell with less material. Thus, a larger electric battery cell may require a larger tolerance than a smaller electric battery cell.

CMD 100 stores data associated with such determination in CMD's memory, for example, in an event log. Such stored data includes an indicator that the cell failed, e.g., a respective flag, and a time stamp. The stored data may also include relevant temperature values and tolerance values. CMD 100 may communicate such data to controller 130 once the determination is made, or store the data for later transmission, for example, in a pre-scheduled time or in response to request from controller for update on the maturation process.

If at step 415 the variance of measurement(s) of the cell temperature from the corresponding value(s) of the controlled room temperature are determined to comply with the respective tolerance(s), e.g., do not exceed the set tolerance(s), the process continues to step 425 to determine whether cell's maturation process reached a predefined stage, such as described with reference to method 200.

If the cell matured sufficiently to be moved to the next stage of manufacture, process 400 continues to step 430 at which a determination is made that the cell passed its manufacturing specification based on temperature analysis. CMD 100 stores data associated with such determination in CMD's memory, for example, in an event log. Such stored data includes an indicator that the cell passed, e.g., a respective flag, and a time stamp. Data stored by CMD 100 may also include temperature values and tolerance values over the maturation period, e.g., stored as a histogram. CMD 100 may communicate to controller 130 that the cell has passed, and optionally include related stored data, immediately, once the determination is made, or store the data for later transmission, for example, in a pre-scheduled time or in response to controller's request for update on the maturation process.

If the cell has not yet reached the predefined maturation stage, process 400 returns to step 405 to obtain further temperature measurements.

The frequency with which the loop including steps 405, 410, 415, and 425 is repeated for temperature measurements may be the same or different from the frequency with which the same loop is repeated for other cell property measurements. This loop for evaluating temperature of the cell may be repeated at regular intervals, e.g., 1 second each, or at regular measurement increments, e.g., 1 degree. The frequency with which the loop is repeated may change as the cell progresses through the maturation stage. For example, if the controlled environment temperature is changing, the frequency with which the loop is repeated may increase. Additionally, or alternatively, the frequency with which the loop is repeated may vary depending on other property measurements at the cell and/or on how maturation of other cells in the same controlled environment progresses and/or how maturation of other cells of the same type progressed through maturation.

### Pressure

Data concerning the pressure inside of an electric battery cell, or as applied to some external face of the cell, during the maturation stage, may provide additional insight into whether the electric battery cell matures as expected according to its manufacturing specification. For example, gas produced inside the cell by unwanted reactions, such as continued reactions between the anode and electrolyte (SEI formation) would result in pressure being increased. As a further example, pressure within the cell retuning to atmospheric pressure indicates a seal failure on the cell. As another example, pouch cells and prismatic cells may be clamped in a jig during their formation and maturation, so that constant pressure measurements can be obtained and checked against respective tolerance to provide for additional quality assurance data.

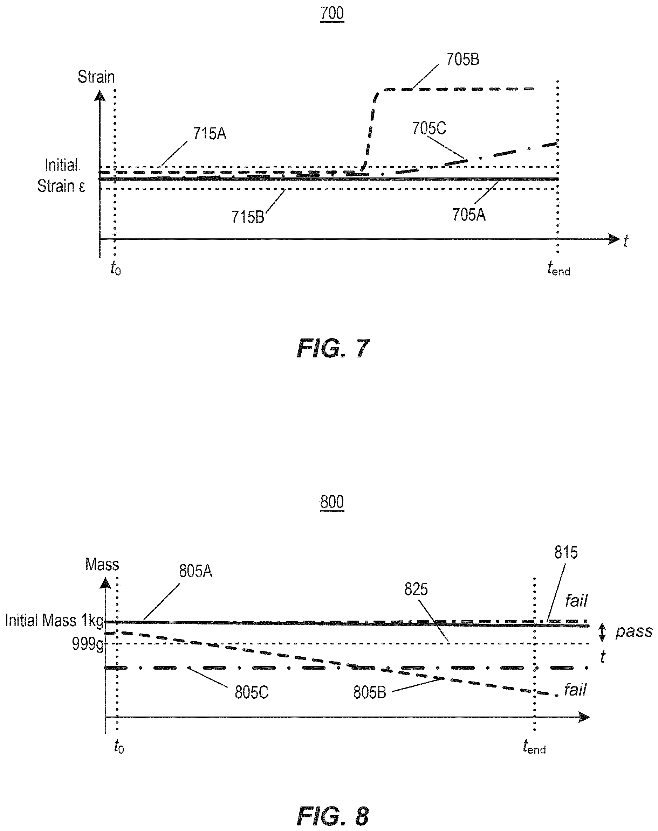

With reference to Figure 6, this figure depicts three functions of pressure over time, functions 605A, 605B, and 605C, corresponding respectively to three pouch cells A, B, and C of the same type and undergoing maturation over time period [*t*₀*_{,} t_{end}*]. A typical pouch cell is vacuum sealed, and therefore has an absolute pressure lower than atmospheric pressure. In Figure 7, the initial pressure (absolute) for pouch cells A, B, and C is around 10kPa.

As cell B progressed through maturation, its pressure, as depicted by function 605B, was stable first. Approximately halfway through time period [*t*₀*, t_{end}*], the pressure increased rapidly to atmospheric pressure level 625 of 101kPA. The cell pressure returning to atmospheric pressure indicates failure of the seal on pouch B, and thus cell B would fail the maturation process. In some embodiments, the controlled environment in which the cell is undergoing maturation may control pressure within the controlled environment and such pressure could be set at a level different from the atmospheric pressure, e.g., lower than the atmospheric pressure. In such embodiments, the pressure of the cell rising to the pressure of the controlled environment would indicate a seal failure on that cell.

As cell C progressed through maturation, its pressure, as depicted by function 605C, was stable first. Approximately halfway through time period [*t*₀*, t_{end}*], the pressure started to increase, rising above predefined threshold 615 of 20kPa. The cell pressure rising about a threshold set by a corresponding manufacturing specification, indicates that unwanted gas has been produced inside cell C, and thus cell C would fail the maturation process.

As cell A progressed through maturation, its pressure, as depicted by function 605A, was generally stable, with a slight rise during the second half time period [*t*₀*, t_{end}*]. However, it stayed well below threshold 615 of 20kP defined for the cell by its manufacturing specification. The cell pressure of a cell remaining within boundaries defined by that cell's manufacturing specification indicates that the cell has matured as expected, even if pressure fluctuated somewhat during the maturation stage. Thus, cell A would pass the maturation process based on pressure analysis.

Initial cell pressure and threshold values depicted in Figure 6 are merely exemplary. Actual values may vary depending on chemistry, format, or a state of a particular cell, pressure within the controlled environment, a desired progression of or timeline for the maturation stage, implementation details or limitations, and the like. All or some of these parameters may be defined by a corresponding manufacturing specification.

Returning to process 400 of Figure 4, when such process is applied to evaluate cell's pressure, CMD 100 obtains measurement(s) of cell's pressure at step 405, for example using an external or internal pressure sensor 114 described with reference to Figure 1. Also at step 405, CMD 100 may receive data indicative of controlled environment's pressure. For example, CMD 100 may receive actual measurements of controlled environment pressure corresponding in time to cell pressure measurements obtained by CMD 100. In some embodiments, CMD 100 may instead be provided with data defining pressure and its changes (e.g., as a function of time) during the maturation period as set to control pressure in the controlled environment. Such data may be set and shared with CMD 100 before starting the maturation stage or updated as the maturation stage progresses.

CMD 100 may also receive tolerance data (such as the pressure threshold), unless previously provided, or updates to previously received tolerance data. In some embodiments, tolerance data is provided for the duration of the maturation stage. In some embodiments, tolerance data may be updated depending on pressure analysis as the cell progresses through maturation. Yet in some embodiments, the tolerance data may be updated depending on pressure analysis during maturation of other cells of the same type and/or undergoing maturation in the same controlled environment.

At step 410, CMD 100 evaluates the pressure measured at the cell by comparing the measured pressure to the respective tolerance value, such as pressure threshold 615. If at step 415 the pressure measurement(s) of the cell exceeds the respective tolerance value (e.g., a set value), then process 400 continues to step 420 at which a determination is made that the cell has failed its manufacturing specification during the maturation stage. CMD 100 stores data associated with such determination in CMD's memory, for example, in an event log. Such stored data includes an indicator that the cell failed, e.g., a respective flag, and a time stamp. The stored data may also include relevant pressure values and tolerance values. CMD 100 may communicate such data to controller 130 once the determination is made, or store the data for later transmission, for example, in a pre-scheduled time or in response to request from controller for update on the maturation process.

If at step 415 the pressure measurement(s) of the cell are determined to comply with the respective tolerance, e.g., do not exceed the set tolerance(s), the process continues to step 425 to determine whether cell's maturation process reached a predefined stage, such as described with reference to method 200.

If the cell matured sufficiently to be moved to the next stage of manufacture, process 400 continues to step 430 at which a determination is made that the cell passed its manufacturing specification based on pressure analysis. CMD 100 stores data associated with such determination in CMD's memory, for example, in an event log. Such stored data includes an indicator that the cell passed, e.g., a respective flag, and a time stamp. Data stored by CMD 100 may also include pressure values and tolerance values over the maturation period, e.g., stored as a histogram. CMD 100 may communicate to controller 130 that the cell has passed, and optionally include related stored data, immediately, once the determination is made, or store the data for later transmission, for example, in a pre-scheduled time or in response to controller's request for update on the maturation process.

If the cell has not yet reached the predefined maturation stage, process 400 returns to step 405 to obtain further pressure measurements.

The frequency with which the loop including steps 405, 410, 415, and 425 is repeated for pressure measurements may be the same or different from the frequency with which the same loop is repeated for other cell property measurements, such as temperature or internal resistance. This loop for evaluating pressure of the cell may be repeated at regular intervals, e.g., 1 second each, or at regular measurement increments, e.g., 1 Pa. The frequency with which the loop is repeated may change as the cell progresses through the maturation stage. For example, if the pressure of the controlled environment changes, the frequency with which the loop is repeated may increase. Additionally, or alternatively, the frequency with which the loop is repeated may vary depending on other property measurements at the cell and/or on how maturation of other cells in the same controlled environment progresses and/or how maturation of other cells of the same type progressed through maturation.

### Strain or Stress

Data concerning the expansion or contraction of an electric battery cell gathered during the maturation stage may provide an additional insight into whether the electric battery cell matures as expected according to its manufacturing specification, and thereby passes or fails the maturation stage. For example, gas produced inside the cell by unwanted reactions, such as continued reactions between the anode and electrolyte (SEI formation) would result in an increased volume or size of the cell, such as of a pouch cell. As a further example, changes in volume or size of the cell may also be indicative of a cell being impacted or dropped. A strain gauge positioned on one of the faces or surfaces of the cell can be used to obtain measurements indicative of the expansion or contraction of the cell.

With reference to Figure 7, this figure depicts three functions of cell strain over time, functions 705A, 705B, and 705C, corresponding respectively to three pouch cells A, B, and C of the same type and undergoing maturation over time period [*t*₀, *t_{end}*].

As cell A progressed through maturation, its strain, as measured on the surface of the cell and depicted by function 705A, generally remained stable and has not risen above strain threshold 715A or fell below strain threshold 715B over the entire maturation period [*t*₀*, t_{end}*]. Cell strain measurements falling within the boundaries defined by that cell's manufacturing specification (threshold function 715A and 715B in Figure 7) for the duration of the maturation stage indicate that the cell has matured as expected, even with some fluctuations in the strain measurements. Thus, cell A would pass the maturation stage based on strain analysis.

As cell B progressed through maturation, its strain, as measured on the surface of the cell and depicted by function 705B, was stable first. However, in the second half of time period [*t*₀*, t_{end}*], the value of strain measurements increased rapidly, almost instantaneously, to substantially above strain threshold 715A. Such a drastic change in strain measurements during the maturation stage indicates that the cell was likely dropped or crushed while undergoing maturation, or a seam of weld of the cell has failed. Thus, cell B would fail the maturation stage.

As cell C progressed through maturation, its strain as measured on the surface of the cell and depicted by function 705C, was stable first. However, in the second half of time period [*t₀, t_{end}*], the value of strain measurements started increasing gradually, eventually exceeding strain threshold 715A, before the maturation stage is complete. Such a gradual change in strain above a pre-defined threshold may result from a change in shape or volume of the cell due to unwanted gas production inside the cell. Thus, cell C would fail the maturation stage.

Although Figure 8 illustrates strain tolerance in the form of upper and lower strain threshold functions 715A and 715B respectively, in some embodiments a single threshold function or threshold constant could be used. For example, a cell may be monitored to ensure that its strain does not exceed an upper threshold or threshold function. Alternatively, or additionally, a threshold function or constant defining a rate of change for cell strain could be used.

Returning to process 400 of Figure 4, when such process is applied to evaluate cell's strain, CMD 100 obtains measurement(s) of cell's strain at step 405, for example using strain gauge 114 positioned on the surface of the cell to measure its expansion and contraction. Also at step 405, CMD 100 may receive tolerance data (such as the strain thresholds 715A and 715B), unless previously provided, or updates to previously received tolerance data. In some embodiments, tolerance data is provided for the duration of the maturation stage. In some embodiments, tolerance data may be updated depending on strain analysis as the cell progresses through maturation. Yet in some embodiments, the tolerance data may be updated depending on strain analysis of other cells of the same type during maturation and/or other cells undergoing maturation in the same controlled environment.

At step 410, CMD 100 evaluates the strain measured at the cell by comparing the measured strain to the respective tolerance value(s), such as strain thresholds 715A and 715B. If at step 415 the strain measurement(s) of the cell exceeds a tolerance value (e.g., a set value), then process 400 continues to step 420 at which a determination is made that the cell has failed its manufacturing specification during the maturation stage. CMD 100 stores data associated with such determination in CMD's memory, for example, in an event log. Such stored data includes an indicator that the cell failed, e.g., a respective flag, and a time stamp. The stored data may also include relevant strain values and tolerance values. CMD 100 may communicate such data to controller 130 once the determination is made, or store the data for later transmission, for example, in a pre-scheduled time or in response to request from controller for update on the maturation process.

If at step 415 the strain measurement(s) of the cell are determined to comply with the respective tolerance(s), e.g., do not exceed the set tolerance(s), the process continues to step 425 to determine whether cell's maturation process reached a predefined stage such that developing of faults is unlikely, such as described with reference to method 200.

If the cell matured sufficiently to be moved to the next stage of manufacture, process 400 continues to step 430 at which a determination is made that the cell passed its manufacturing specification based on strain analysis. CMD 100 stores data associated with such determination in CMD's memory, for example, in an event log. Such stored data includes an indicator that the cell passed, e.g., a respective flag, and a time stamp. Data stored by CMD 100 may also include strain values and tolerance values over the maturation period, e.g., stored as a histogram. CMD 100 may communicate to controller 130 that the cell has passed, and optionally include related stored data, immediately once the determination is made, or store the data for later transmission, for example, in a pre-scheduled time or in response to controller's request for update on the maturation process.

If the cell has not yet reached the predefined maturation stage, process 400 returns to step 405 to obtain further strain measurements.

The frequency with which the loop including steps 405, 410, 415, and 425 is repeated for strain measurements may be the same or different from the frequency with which the same loop is repeated for other cell property measurements, such as temperature or pressure. This loop for evaluating pressure of the cell may be repeated at regular intervals, e.g., 1 second each, or at regular measurement increments, such as at each measurement unit, e.g., each 10kPa interval. The frequency with which the loop is repeated may change as the cell progresses through the maturation stage. For example, if the pressure of the controlled environment changes, the frequency with which the loop is repeated may increase. Additionally, or alternatively, the frequency with which the loop is repeated may vary depending on other property measurements at the cell and/or on how maturation of other cells in the same controlled environment progresses and/or how maturation of other cells of the same type progressed through maturation.

### Weight

Data concerning an electric battery cell's weight gathered during the maturation stage may provide an additional insight into whether the electric battery cell has matured as expected, i.e., according to its manufacturing specification, and thus whether it has passed or failed the maturation stage. For example, electrolyte leakage due to failure in the electric battery cell's seal would result in loss of mass of the cell. Missing components from the cell assembly would result in mass of the cell being lower than an expected cell mass for that type of the cell. An external measuring device, such as a scale placed on or incorporated with a storage housing (e.g., shelf) holding the cell during the maturation stage in the controlled environment, may be used to weigh the cell and then communicate respective measurements to CMD 100.

With reference to Figure 8, this figure depicts three functions of cell mass over time, functions 805A, 805B, and 805C corresponding respectively to three pouch cells A, B, and C undergoing maturation over time period [*t*₀*, t_{end}*]. Cells A, B, and C are of the same type, and thus share a common manufacturing specification.

Cell A started the maturation stage with the initial mass of 1 kg. This weight corresponds to expected mass 815 of 1 kg for the type of cell A. As cell A progressed through the maturation stage (i.e., matured), its cell mass generally remained stable (depicted by function 805A). Cell A experienced some loss of mass toward the end of time period [*t*₀*, t_{end}*] of the maturation stage. However, that loss was not substantial and did not exceed corresponding threshold 825 of 0.999 kg during the entire maturation period [*t₀, t_{end}*]. Mass measurements falling within the boundaries defined by that cell's manufacturing specification (no lower than threshold 825) for the duration of the maturation stage indicate that the cell has matured as expected, even when the cell experienced some mass loss. Thus, cell A would pass the maturation stage based on cell mass analysis.

Cell B started the maturation stage with the initial mass slightly below expected mass 815 of 1 kg but within the accepted tolerance, i.e., with initial mass being above threshold 825 of 0.999 kg. As cell B progressed through the maturation stage, its cell mass decreased, falling below threshold 825 of 0.999 kg shortly after the maturation stage started and continued to fall (as depicted by function 805B). Such extensive mass loss may indicate electrolyte leaks from the cell, such as due to failure of the cell seal. Thus, cell B would fail the maturation stage based on cell mass analysis.

Cell C started the maturation stage with the initial mass below expected mass 815 of 1 kg, exceeding the accepted tolerance, i.e., with the initial mass also being below threshold 825 of 0.999 kg. As cell C progressed through maturation, its cell mass remained constantly below threshold 825. Such below-expected-measurements of cell mass, even if they are consistent, may indicate that the cell's assembly is missing one or more components. Thus, cell C would fail the maturation stage based on cell mass analysis.

Returning to process 400 of Figure 4, when such process is applied to evaluate cell's mass, CMD 100 obtains measurement(s) of cell mass at step 405, for example using an external measurement device. Also at step 405, CMD 100 may receive tolerance data (such as mass threshold 825) and/or expected mass value for the respective call unless, for example, such data has been previously provided. At step 100 may also receive updates to the previously received tolerance data. In some embodiments, tolerance data is provided for the duration of the maturation stage. In some embodiments, tolerance data may be updated depending on the results of mass analysis as the cell matures. In some embodiments, the tolerance data may be updated depending on mass analysis during the maturation stage for other cells of the same type and/or depending on mass analysis of other cells undergoing maturation in the same controlled environment.

At step 410, CMD 100 evaluates the cell mass by comparing it to the respective expected mass, using tolerance value(s) such as mass thresholds 825. If at step 415 the mass measurement(s) of the cell exceed a tolerance value (e.g., a set value), then process 400 continues to step 420 at which a determination is made that the cell has failed its manufacturing specification during the maturation stage. CMD 100 stores data associated with such determination in CMD's memory, for example, in an event log. Such stored data includes an indicator that the cell failed, e.g., a respective flag, and a time stamp. The stored data may also include relevant mass values and tolerance values. CMD 100 may communicate such data to controller 130 once the determination is made, or store the data for later transmission, for example, in a pre-scheduled time or in response to request from controller for update on the maturation process.

If at step 415 the mass measurement(s) of the cell are determined to comply with the respective tolerance(s), e.g., do not exceed the set tolerance(s), the process continues to step 425 to determine whether cell's maturation process reached a predefined stage, such as described with reference to method 200.

If the cell matured sufficiently to be moved to the next stage of manufacture, process 400 continues to step 430 at which a determination is made that the cell passed its manufacturing specification based on strain analysis. CMD 100 stores data associated with such determination in CMD's memory, for example, in an event log. Such stored data includes an indicator that the cell passed, e.g., a respective flag, and a time stamp. Data stored by CMD 100 may also include strain values and tolerance values over the maturation period, e.g., stored as a histogram. CMD 100 may communicate to controller 130 that the cell has passed, and optionally include related stored data, immediately once the determination is made, or store the data for later transmission, for example, in a pre-scheduled time or in response to controller's request for update on the maturation process.

If the cell has not yet reached the predefined maturation stage, process 400 returns to step 405 to obtain further strain measurements.

The frequency with which the loop including steps 405, 410, 415, and 425 is repeated for strain measurements may be the same or different from the frequency with which the same loop is repeated for other cell property measurements, such as temperature or pressure. This loop for evaluating pressure of the cell may be repeated at regular intervals, e.g., 1 second each interval, or at regular measurement increments, e.g., at each change of 0.001 kg. The frequency with which the loop is repeated may change as the cell progresses through the maturation stage. For example, if the mass of the cell changes, the frequency with which the loop is repeated may increase.

Additionally, or alternatively, the frequency with which the loop is repeated may vary depending on other property measurements at the cell and/or on how maturation of other cells in the same controlled environment progresses and/or how maturation of other cells of the same type progressed through maturation. For example, if the pressure or strain of the cell increases, particularly if the pressure or strain of the cell increases rapidly, or a mechanical deformation is detected, the frequency with which the temperature is measured could be increased to monitor for possible thermal runaway event.

In some embodiments, CMD 100 continues to monitor cell maturation after determining the electric battery cell deviated from its manufacturing specification. For example, if the electric battery cell has a failure due to an elevated temperature, the CMD may continue to monitor the temperature in case the electric cell becomes dangerously hot, causing a fire hazard. **In** this scenario, CMD 100 may issue an alert that the electric battery cell requires immediate attention.

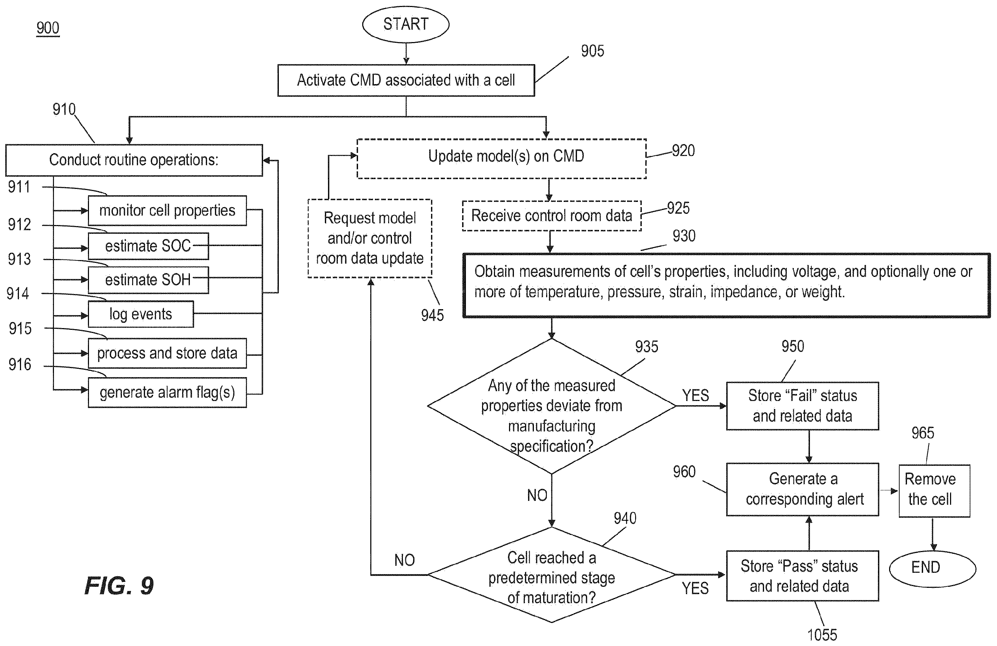

Figure 9 depicts method 900 for monitoring or managing a maturation stage of an electric battery cell, according to some embodiments.

Method 905 starts with step, at which a CMD, e.g., CMD 100, associated with an electric battery cell is activated. For example, CMD 100 may be physically connected to a cell and is powered up for the first time. Once powered, CMD 100 may be programmed with data enabling CMD 100 to evaluate or facilitate evaluation of whether the electric battery cell matures according to that electric battery cell's manufacturing specification. For example, CMD 100 may be programmed with cell specific parameters, such as safety limits for voltage, temperature, resistance, state of charge, and state of health algorithms and any relevant manufacturing information, such as the cell ID number. Different type of parameters and thresholds, as well as how they are used to evaluate cell property measurement obtained at the cell to determine whether an electric battery cell has matured according to its specification and ready to be moved to next manufacturing stage, such as shipping, or deviated from the manufacturing specification so it is no longer suitable for use for its intended purpose. Details of parameters that could be used and how evaluation can be performed by CMD 100 discussed in greater detail with reference to Figures 1 to 8 and are similarly applicable in the context of method 900.

Once the activation stage has been completed, CMD 100 operates in its normal modes, constantly or continuously monitoring cell properties (such as voltage, temperature, and any other parameters such at pressure), storing obtained measurements of cell properties and results of their processing (e.g., estimating and storing State of Charge or State of Health of electric battery cell), logging events, generating alerts or alarms (e.g., by flagging), and performing other routine operations. CMD 100 can run such processes in parallel or substantially in parallel.

For example, as shown in Figure 9, at step 910, CMD 100 conducts routine operations, including: monitoring cell properties (step 911), estimating state of charge (step 912), estimating state of health (step 913), logging events (step 914), processing and storing data (915), and generating alarm flag(s) (step 916). **In** some embodiments, CMD 100 runs each of such routine operations with the same frequency. **In** some embodiments, some of routine operations 911-916 run with a different frequency then others. For example, CMD 100 may estimate SOH less frequently than SOC. **In** some embodiments, some of routine operations 911-916 run on as needed basis. For example, an alarm flag may be generated only when a predetermined type of event is detected.

In parallel to CMD 100 running its routine operations, the corresponding electric battery cell undergoes maturation. As described in detail with reference to Figures 1 to 8, CMD 100 is programmed with parameters specific to the maturation process, such as voltage and internal resistance tolerance, according to the manufacturing specification of the electric battery cell monitored by CMD 100. Specifically, CMD 100 may employ one or more models defined for the monitored electric battery cell according to its manufacturing specification. The model(s) can be preprogrammed, and updated (step 920) at the activation stage and/or as the electric battery cell progresses through maturation. CMD 100 is also programmed with desired sampling rates for measuring different properties of the monitored electric battery cell, such within or in association with corresponding model(s) stored at CMD 100.

As also described in detail with reference to Figures 1 to 8, at step CMD 100 measures cell properties parameters and calculates any subsequent values, such as *dV*/*dt & d2V*/*dt2*) in accordance with corresponding model(s) and sampling rates. CMD 100 may send a request to the control room for additional parameters, such as the control room temperature and humidity and receive (step 925) such information from a control system of the control room.

If CMD 100 determines (step 935) that any of the measured properties deviate from the manufacturing specification (as described in detail with reference to Figures 1 to 8), then, at step 950, CMD 100 updates the status of the electric battery cell to "fail" and stores related data, such as the obtained measurements and results of their processing. CMD 100 then generates (step 960) a corresponding alert that is transmitted to a remote controller.

If CMD 100 determines (step 935) that none of the measured properties deviate from the manufacturing specification, then, at step 940, CMD 100 determines whether the electric battery cell has reached a predetermined stage for removing the electric battery cell from the controlled room. For example, the predetermined stage could be defined as a voltage-dependent behaviour of the electric battery cell indicative of a probability of the electric battery cell exhibiting a manufacturing fault while continuing to undergo maturation after reaching the predetermined stage being below a predetermined level. If CMD 100 determines that the electric battery cell reached the predetermined stage for removing the electric battery cell from the controlled room, CMD 100, at step 955, updates the status of the electric battery cell to "pass" and stores related data, such as the obtained measurements and results of their processing. CMD 100 then generates (step 960) a corresponding alert that is transmitted to a remote controller.

In some embodiments, CMD 100 transmits the alert to the remote controller immediately upon generation. In some embodiments, CMD 100 stores such an alert and transmits it only in request from the remote controller. In some embodiments, CMD 100 transmits urgent alerts without delay, such as upon detecting a hazardous fault, e.g., a thermal runaway, and stored non-urgent alerts for subsequent retrieval, e.g., the electric battery cell has reached its predetermined maturation stage and is ready for removal from the controlled room.

If CMD 100 determines that the electric battery cell has not reached the predetermined maturation stage, method 900 restarts the loop of obtaining measurement of cell properties and evaluating such measurements (steps 930, 935, and 940). Before restarting the loop, CMD 100 may request updates for model(s) CMD 100 uses to evaluate cell measurements and.pr of control room data.

Once CMD 100 that the electric battery cell either failed or passed, the electric battery cell is removed from the controlled room (step 965). If CMD 100 remains electrically coupled with the electric battery cell, CMD 100 main continue obtaining and processing measurements of cell properties and store such measurements and results of processing for during of electric battery cell's life. In some embodiments, CMD 100 is configured for decoupling from the electric battery cell and coupling with another electric battery cell for monitoring progression of such a subsequent electric battery cell through maturation. In such embodiments, CMD 100 may be reprogrammed according to the manufacturing specification of the subsequent electric battery cell.

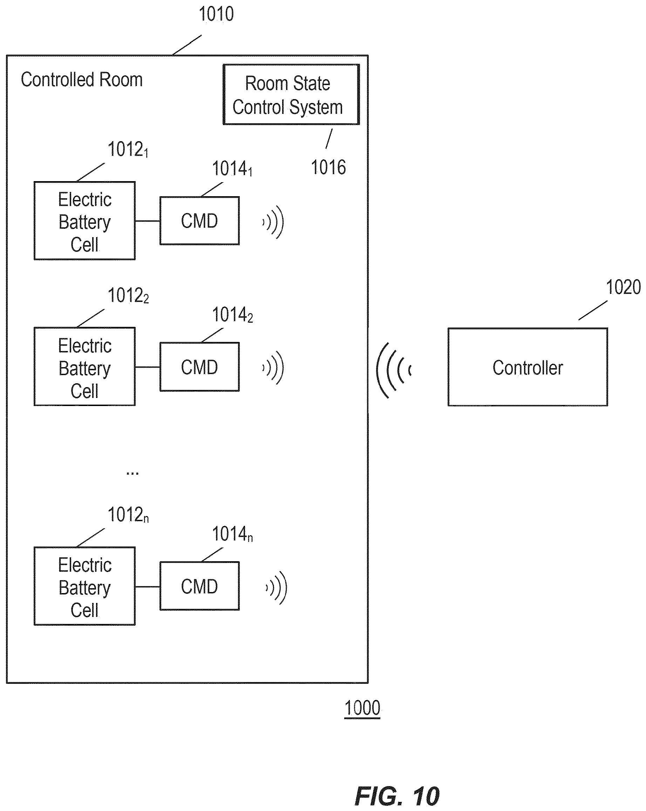

Figure 10 depicts an example of a cell monitoring system (CMS) for monitoring maturation of electric battery cells in a controlled environment, such as a controlled room, according to some embodiments. A CMS 1000 shown in Figure 11 includes a controlled room 1010 that houses a plurality of cell monitoring devices (CMDs) 1014₁, 1014₂ ... 1014ₙ, and a controller communicatively coupled with CMDs 1014₁, 1014₂ ... 1014ₙ, e.g., wirelessly. Controller 1020 can be internal or external to controlled room 1010. Electric battery cells 1012₁, 1012₂ ... 1012ₙ are placed into controlled room 1010, so as to undergo maturation in a controlled environment, and are electrically coupled to corresponding CMDs 1014₁, 1014₂ ... 1014ₙ, to allow CMDs 1014₁, 1014₂ ... 1014ₙ to monitor how electric battery cells 1012₁, 1012₂ ... 1012ₙ progress through.

Controlled room 1010 includes a control system 1016 for controlling the state of controlled room 1010, such as temperature and/or humidity within controlled room 1010. For example, control system 1016 may be configured to maintain consistent temperature and/or humidity or vary temperature and/or humidity as electric battery cells 1012₁, 1012₂ ... 1012, undergo maturation. Control system 1016 may vary temperature and/or humidity according to a preset pattern, or responsive to command(s) received from controller 1020, or responsive to changes in the control room's state occurring within control room 1010. Control system 1016 may also be configured to take measurements of controlled room environment, e.g., its temperature and/or humidity, to determine the state of controlled room and share results of determination with controller 1020

Each CMD 1014₁, 1014₂ ... 1014ₙ is configured to obtain repeatedly at a sampling rate, using a voltage sensor, voltage measurements of corresponding electric battery cell 1012₁, 1012₂ ... 1012ₙ, calculate a rate of change for voltage based on the voltage measurements relative to the sampling rate, and transmit the voltage measurements and the calculated rate of change to controller 1020. For each electric battery cell 1012₁, 1012₂ ... 1012ₙ, controller 1020 is configured to evaluate the received voltage measurements and rate of change, using a model defined for the electric battery cell according to a manufacturing specification of that electric battery cell. In this manner, controller 1020 is able to determine whether the electric battery cell deviated from the manufacturing specification or reached a predetermined stage of maturation for removing the electric battery cell from controlled room 1010.

Controller 1020 may use different modes for different electric battery cells 1012₁, 1012₂ ... 1012ₙ. Where electric battery cells 1012₁, 1012₂ ... 1012ₙ have manufacturing specification that match or the same manufacturing specification, e.g., electric battery cells of the same type and with the same characteristics, controller 1020 may use a single model for evaluating voltage measurements of all such cells.

The model or models used by controller 1020 include one or more voltage-dependent functions. The one or more voltage-dependent functions may be a function for defining a state of maturation of the electric battery cell in which a probability of the electric battery cell exhibiting a manufacturing fault while continuing to undergo maturation is being below a predetermined level. For example, the function for defining the state of maturation may comprise a range for a second derivative of voltage of the electric battery cell over time.

Controller 1030 is configured, upon determining that the electric battery cell deviated from the manufacturing specification or reached the predetermined stage of maturation, to issue a corresponding alert. For example, controller 1030 may transmit a message to a designated operator that a particular electric battery cell failed to mature successfully, or has successfully matured, and could be removed from controlled room 1010, for example, to be shipped.

Whether an electric battery cell reaches the predetermined stage of maturation may be defined by setting a range for a second derivative of voltage of the electric battery cell over time. Controller 1020 may be configured to determine that the corresponding electric battery cell reached the predetermined stage of maturation upon determining that the second derivative of voltage over time of the electric battery cells is within the range for the second derivative defined by the corresponding function and that the electric battery cell has not deviated from the manufacturing specification.

**In** some embodiments, controller 1020 may be configured to update the model in response to changes in the predetermined level, such as based on results of prior evaluation of similar electric battery cells.

One or more models used by controller 1020 may include one or more of: a voltage-dependent function defining expected changes in voltage of the electric battery cell indicative of as-expected maturation when exhibited by the electric battery cell undergoing maturation; a voltage-dependent function defining one or more voltage thresholds indicative of a manufacturing fault at the electric battery cell when crossed by the voltage of the electric battery cell; a voltage-dependent function defining changes in voltage indicative of a manufacturing fault at the electric battery cell when exhibited by the voltage of the electric battery cell; a voltage-dependent function defining expected changes in a rate of change of voltage indicative of as-expected maturation when exhibited by the electric battery cell undergoing maturation; a voltage-dependent function defining one or more rate thresholds indicative of a manufacturing fault when crossed by the rate of change of voltage of the electric battery cell; or a voltage-dependent function defining changes in the rate of change of voltage indicative of a manufacturing fault at the electric battery cell when exhibited by the rate of change of voltage of the electric battery cell.

One or more models used by controller 1020 may also include one or more tolerances defined for at least one of the voltage-dependent functions used by the controller when evaluating the voltage measurements or the calculated rate of change. The one or more tolerances defined for the at least one voltage-dependent function may be time-dependent relative to the electric battery cell undergoing maturation (e.g., increase or decrease as the electric battery cell undergoing maturation), or adjustable responsive to the state of the controlled room or changes in the state of controlled room 1010.

In some embodiments, each of CMDs 1014₁, 1014₂ ... 1014ₙ may be configured to obtain one or more measurements of one or properties of corresponding electric battery cell 1012₁, 1012₂ ... 1012ₙ, such as temperature, pressure, strain, impedance, or weight, in addition to voltage, using a corresponding sensor and transmit the obtained one or more property measurements to controller 1020. In such embodiments, controller 1020 may be configured to evaluate one or more property measurements received from CMDs 1014₁, 1014₂ ... 1014ₙ using a corresponding model or models to determine whether respective electric battery cell(s) deviated from its(their) manufacturing specification, where the model(s) include one or more property-dependent functions corresponding to measured cell property or properties. CMDs 1014₁, 1014₂ ... 1014ₙ is configured to obtain and transmit property measurements for different cell properties in addition to voltage.

In some embodiments, for at least one designated property of the electric battery cell, in addition to voltage, one or more models used by controller 1020 include one or more of: a property-dependent function defining expected changes in the designated property of the electric battery cell indicative of as-expected maturation when exhibited by the electric battery cell undergoing maturation; a property-dependent function defining one or more property thresholds indicative of a manufacturing fault at the electric battery cell when crossed by the designated property of the electric battery cell; a property-dependent function defining changes in the designated property indicative of a manufacturing fault at the electric battery cell when exhibited by the designated property of the electric battery cell; a property-dependent function defining expected changes in a rate of change of the designated property indicative of as-expected maturation when exhibited by the electric battery cell undergoing maturation; a property-dependent function defining one or more rate thresholds for the rate of change of the designated property indicative of a manufacturing fault when crossed by the rate of change of the designated property the electric battery cell; or a property-dependent function defining changes in the rate of change of the designated property indicative of a manufacturing fault at the electric battery cell when exhibited by the rate of change of the designated property of electric battery cell.

Model(s) used by controller 1020 may include a function defining one or more of: changes in one cell property relative to changes in another cell property, changes in a rate of change for one cell property relative to changes in a rate of change for another cell property, changes in one cell property relative to changes in a rate of change for another cell property, or a rate of change for one cell property relative to changes in another cell property relative.

Additionally or alternatively, model(s) used by controller 1020 may include one or more tolerances defined for at least one property-dependent function for use by controller 1120 when evaluating corresponding one or more property measurements or rate of change.

The one or more tolerances may be time-dependent relative to an electric battery cell undergoing maturation, or adjustable responsive to the state of controlled room 1110 or changes in the state of controlled room 1010. Additionally or alternatively, model(s) used by controller 1020 could be time-dependent relative to a respective electric battery cell undergoing maturation.

As described elsewhere in this application, each CMD 1014₁, 1014₂ ... 1014ₙ may be configured to also evaluate cell property measurements it obtains, including voltage, using respective model(s). In such example systems, CMD 1014₁, 1014₂ ... 1014ₙ may share with controller 1020 results of evaluation in addition to, or instead of, cell property measurements they obtain. Controller 1020 may rely on such evaluation results to determine whether a particular electric battery cell deviated from its manufacturing specification or reached a predetermined maturation stage either fully or for comparison with controller's own evaluations, for example to improve accuracy of such evaluation.

Controller 1120 may be configured to update model(s) of one or more CMDs 1014₁, 1014₂ ... 1014ₙ, including prior to being coupled electrically with corresponding electric battery cell 1012₁, 1012₂ ... 1012ₙ, or while such an electric battery cell is undergoing maturation. For example, controller 1020 may be configured to update a model of a particular CMD based on a current state of the controlled room or changes in the state of the controlled room. Controller 1020 may receive one or more measurements (e.g., of temperature and/or humidity) indicative of the state of the controlled environment from room state control system 1016 and update the model based on the one or more measurements.

Additionally or alternatively, controller 1020 may be configured to update model(s) of one or more CMDs 1014₁, 1014₂ ... 1014ₙ monitoring maturation of one electric battery cell based on property measurements obtained by another CMD 1014₁, 1014₂ ... 1014ₙ at another electric battery cell while that electric battery cell was undergoing maturation in a controlled environment until reaching the predetermined stage of maturation.

In some embodiments, controller 1020 may be configured to diagnose a possible cause of an electric battery cell 1012₁, 1012₂ ... 1012ₙ deviating from its manufacturing specification responsive to determining a deviation, or learning about such a deviation from corresponding CMD 1014₁, 1014₂ ... 1014ₙ. Controller 1020 may run diagnostics for each failed parameter, (i.e. cell property), including voltage, based on corresponding measurements received from the respective CMD while the electric battery cell was undergoing the maturation, and any related calculations performed by the CMD to determine a cause of failure. For example, controller 1020 may compare such received data to data indicative of known or previously determined faults or model faults.

In some embodiments, controller 1020 may be configured to determine a possible cause of the electric battery cell deviating from the manufacturing specification using additional property measurements of other electric battery cells in controlled room 1010. By comparing behaviour of multiple electric battery cell, common patters could be identified, and thus possible causes could be deduced. For example, where multiple electric battery cells from the same manufacturing batch are exhibiting the same faulty behaviour, controller 1020 may determine that a fault is not cell specific but rather is with their manufacturing process. Depending on specific changes in property measurements, faults could be determined with greater specificity. For example, if multiple electric battery cells had their weight reduced below a standard operating threshold, the cause may be identified as a problem with how electric battery cells are being sealed during their manufacture.

In some embodiments, responsive to determining that electric battery cell 1012₁, 1012₂ ... 1012ₙ reached the predetermined stage of maturation, controller 1020 may be configured to grade the quality of such an electric battery cell using the property measurements, including voltage measurements, received from respective CMD 1014₁, 1014₂ ... 1014ₙ while the electric battery cell was undergoing the maturation. For example, controller 1020 may grade the electric battery cell based on how close or far its measurements from what is defined by the corresponding manufacturing specification. Additionally, or alternatively, controller 1020 may use corresponding property measurements of other electric battery cells, such of the same type and/or undergoing maturation at the same time in the same controlled room. Consistency with such measurements may be indicative of a "good" electric battery cell, i.e., an electric battery cell that could be put in operation for its intended use, while deviations from such may be indicative of a not so "good" cell, even if no fault has been developed, where the electric battery cell could be appropriate to a different application, e.g., storage grid instead of an electric vehicle.

In some embodiments, CMDs 1014₁, 1014₂ ... 1014ₙ are detachably coupled with corresponding electric battery cells 1012₁, 1012₂ ... 1012ₙ. For example, CMDs 1114₁, 1014₂ ... 1014ₙ may be housed within controlled room 1010 for monitoring batches of electric battery cells 1012₁, 1012₂ ... 1012ₙ, where once a batch of electric battery cells 1012₁, 1012₂ ... 1012ₙ is removed from controlled room 1010, e.g., upon such electric battery cells reaching their predetermined stage of maturation, a new batch of electric battery cells 1012₁, 1012₂ ... 1012ₙ is brought into controlled room 1010 and coupled with CMDs 1014₁, 1014₂ ... 1014ₙ.

In some embodiments, each CMD 1014₁, 1014₂ ... 1014ₙ is configured to be the sole electrical load of corresponding electric battery cell 1012₁, 1012₂ ... 1012ₙ while such an electric battery cell is undergoing maturation in controlled room 1010.

In some embodiments, each CMD 1014₁, 1014₂ ... 1014ₙ has memory for storing property measurements obtained at corresponding electric battery cell 1012₁, 1012₂ ... 1012ₙ and results of any respective calculations performed by CMD 1014₁, 1014₂ ... 1014ₙ. Controller 1020 may be configured to retrieve any of the stored property measurements and results from the memory of 1014₁, 1014₂ ... 1014ₙ including after corresponding electric battery cell 1012₁, 1012₂ ... 1012ₙ reaches the predetermined stage of maturation, for example during or post-shipping, where CMD 1014₁, 1014₂ ... 1014ₙ and electric battery cell 1012₁, 1012₂ ... 1012ₙ remain electrically coupled post-maturation, such as where CMD 1014₁, 1014₂ ... 1114ₙ is embedded within a structure of electric battery cell 1012₁, 1012₂ ... 1012ₙ.

Controller 1020 may be configured to prepare reports based on results of its valuations, such as single cell or multi cell failure, which electric battery cells are ready to be removed from controlled room 1010, which cells are fit for service and which may need to be moved to secondary application, etc.

In some embodiments, electric battery cells 1012₁, 1012₂ ... 1012ₙ are removed from controlled room 1010 as a group, once all cells or a batch of cells have either reached their predetermined stage of maturation or deviated from their manufacturing specification, and then sorted according to controller's evaluation results, e.g., based on its reports. In some embodiments, electric battery cells 1012₁, 1012₂ ... 1012ₙ are removed individually responsive to the cell deviating from its manufacturing specification or be ready for removal because it reached the predetermined stage of maturation. In some embodiments, electric battery cells 1012₁, 1012₂ ... 1012ₙ are removed from controlled room 1110 as a group, unless deviation from the manufacturing specification by a particular electric battery cell or cells is indicative of hazardous fault, such a thermal runaway that may result in a fire.

Cells 1012₁, 1012₂ ... 1012ₙ may be removed from controlled room 1010 using robotic systems controlled by controller 1020.

Various operations or functions described herein, such as those performed by a CMD or a CMS, may be implemented or defined as software code or instructions. Such content may be directly executable ("object" or "executable" form), source code, or difference code ("delta" or "patch" code). Software implementations of the embodiments described herein may be provided via an article of manufacture with the code or instructions stored thereon, or via a communication interface method to send data via the communication interface. A machine or computer readable storage medium may cause a machine to perform the functions or operations described and includes any mechanism that stores information in a form accessible by a machine (e.g., computing device, electronic system, and the like), such as recordable/non-recordable media (e.g., read only memory (ROM), random access memory (RAM), magnetic disk storage media, optical storage media, flash memory devices, and the like). A communication interface includes any mechanism that interfaces with any of a hardwired, wireless, optical, or similar, medium to communicate with another device, such as a memory bus interface, a processor bus interface, an Internet connection, a disk controller, and the like. The communication interface may be configured by providing configuration parameters and/or sending signals to prepare the communication interface to provide a data signal describing the software content. The communication interface may be accessed via one or more commands or signals sent to the communication interface.

Embodiments of the present disclosure may be implemented with computer executable instructions. The computer-executable instructions may be organized into one or more computer-executable components or modules. Aspects of the disclosure may be implemented with any number and organization of such components or modules. For example, aspects of the disclosure are not limited to the specific computer-executable instructions or the specific components or modules illustrated in the figures and described herein. Other embodiments may include different computer-executable instructions or components having more or less functionality than illustrated and described herein.

Computer programs based on the written description and methods of this specification are within a software developer's skill. The various programs or program modules may be created using a variety of programming techniques. For example, program sections or program modules may be designed by means of JavaScript, Scala, Python, Java, C, C++, assembly language, or any such programming languages, as well as data encoding languages (such as XML, JSON, etc.), query languages (such as SQL), presentation-related languages (such as HTML, CSS, etc.) and data transformation language (such as XSL). One or more of such software sections or modules may be integrated into a computer system, non-transitory computer readable media, or existing communications software.

The descriptions of the various embodiments of the present disclosure have been presented for purposes of illustration and are not intended to be exhaustive or limiting to the scope of the disclosure. Many modifications and variations of the disclosed embodiments will be apparent to those of ordinary skill in the art from the herein disclosed embodiments, without departing from the scope of the disclosure. The terminology used herein to disclose the embodiments of the disclosure was chosen to best explain the principles of the embodiments, the practical application or technical improvement over technologies found in the marketplace, or to enable others of ordinary skill in the art to understand the embodiments disclosed herein.

It is appreciated that certain features of the disclosure, which are, for clarity, described in the context of separate embodiments, may also be provided in combination in a single embodiment. Conversely, various features of the disclosure, which are, for brevity, described in the context of a single embodiment, may also be provided separately or in any suitable sub-combination or as suitable in any other described embodiment of the disclosure. Certain features described in the context of various embodiments are not to be considered essential features of those embodiments unless the embodiment is inoperative without those elements.

Although the disclosure has been described in conjunction with specific embodiments thereof, it is evident that many alternatives, modifications, and variations will be apparent to those skilled in the art. Accordingly, it is intended to embrace all such alternatives, modifications and variations that fall within the scope of the appended claims.

## Claims

1. A cell monitoring device, CMD (100), for use with an electric battery cell while the electric battery cell is electrically coupled to the CMD (100) and undergoing maturation in a controlled environment, after being charged, the CMD (100) comprising circuitry configured to execute operations for causing the CMD (100) to repeatedly:
obtain (205), using a voltage sensor, voltage measurements of the electric battery cell, at a sampling rate,
calculate (210) a rate of change for voltage based on the voltage measurements relative to the sampling rate, and
evaluate (215, 220) the obtained voltage measurements and the calculated rate of change using a model defined for the electric battery cell according to a manufacturing specification of the electric battery cell, to determine (225, 230) whether the electric battery cell deviated from the manufacturing specification, or reached a predetermined stage of maturation for removing the electric battery cell from the controlled environment, the model comprising one or more voltage-dependent functions, the one or more functions comprising a function for defining a state of maturation of the electric battery cell in which a probability of the electric battery cell exhibiting a manufacturing fault while continuing to undergo maturation is below a predetermined level, the function used determine that the electric cell reached the predetermined stage of maturation; and
to generate (235), upon determining that the electric battery cell reached the predetermined stage of maturation for removing the electric battery cell from the controlled environment, a corresponding alert.

2. The CMD of claim 1, wherein the function for defining the state of maturation comprises a range for a second derivative of voltage of the electric battery cell over time.

3. The CMD of claim 2, wherein the circuitry is configured to execute operations for causing the CMD to determine that the electric battery reached the predetermined stage of maturation upon determining that the second derivative of voltage over time of the electric battery cells is within the range for the second derivative defined by the corresponding function and that the electric battery cell has not deviated from the manufacturing specification.

4. The CMD of any of claims 1 to 3, wherein the model comprises at least one of:
a voltage-dependent function defining expected changes in voltage of the electric battery cell, indicative of as-expected maturation, when exhibited by the electric battery cell undergoing maturation,
a voltage-dependent function defining one or more voltage thresholds, indicative of a manufacturing fault at the electric battery cell, when crossed by the voltage of the electric battery cell,
a voltage-dependent function defining changes in voltage, indicative of a manufacturing fault at the electric battery cell, when exhibited by the voltage of the electric battery cell,
a voltage-dependent function defining expected changes in a rate of change of voltage, indicative of as-expected maturation, when exhibited by the electric battery cell undergoing maturation,
a voltage-dependent function defining one or more rate thresholds, indicative of a manufacturing fault, when crossed by the rate of change of voltage of the electric battery cell, or
a voltage-dependent function defining changes in the rate of change of voltage, indicative of a manufacturing fault at the electric battery cell, when exhibited by the rate of change of voltage of the electric battery cell.

5. The CMD of claim 4, wherein the model comprises one or more tolerances defined for at least one of the voltage-dependent functions used when evaluating the voltage measurements or the calculated rate of change,
optionally wherein the one or more tolerances defined for the at last one voltage-dependent function are time-dependent relative to the electric battery cell undergoing maturation and/or adjustable based on a state of the controlled environment.

6. The CMD of any of claims 1 to 5, wherein the circuitry is configured to execute operations for causing the CMD (100) to:
obtain one or more property measurements of a property of the electric battery cell, in addition to voltage, using a corresponding sensor, the electric battery cell having a plurality of properties including voltage; and
evaluate the obtained one or more property measurements using the model to determine whether the electric battery cell deviated from the manufacturing specification, the model comprising at least one property-dependent function corresponding to the property.

7. The CMD of claim 6, wherein the circuitry is configured to execute operations for causing the CMD (100) to obtain and evaluate the one or more property measurements for different properties of the electric battery cells in addition to voltage,
optionally wherein the circuitry is configured to execute operations for causing the CMD (100) to repeatedly obtain and evaluate the one or more property measurements.

8. The CMD (100) of any of claims 1 to 7, wherein the CMD (100) is configured for: embedding into the electric battery cell, attaching to the electric battery cell, or subsequent removal from the electric battery cell.

9. The CMD of any of claims 1 to 8, wherein the CMD (100) is configured to be the sole electrical load of the electric battery cell while the electric battery cell is undergoing maturation in the controlled environment.

10. The CMD of any of claims 1 to 9, comprising memory, wherein:
the circuitry is configured to execute functions for causing the CMD (100) to store property measurements obtained at the electric battery cell and resulting calculations in the memory of the CMD (100) for subsequent retrieval by the CMD (100) or a remote controller, including after the electric battery cell reached the predetermined stage of maturation; and/or
the model is stored in the memory of the CMD (100).

11. A cell monitoring system, CMS, for use with a plurality of electric battery cells while the plurality of electric battery cell is undergoing maturation in a controlled environment, after being charged, the CMS comprising:
a plurality of CMDs (100) of any of claims 1 to 11, each CMD (100) configured to be electrically coupled to one the plurality of electric battery cells; and
a controller (130) in communication with the plurality of CMDs (100),
wherein each CMD (100) is configured, upon determining that the corresponding electric battery cell deviated from the manufacturing specification or reached the predetermined stage of maturation, transmit the corresponding alert to the controller.

12. A cell monitoring system, CMS, for use with a plurality of electric battery cells while the plurality of electric battery cells is undergoing maturation in a controlled environment, after being charged, the CMS comprising:
a plurality of cell monitoring devices, CMDs (1014₁, 1014₂, 1014ₙ), each CMD configured to be electrically coupled to one of the plurality of electric battery cells (1012₁, 1012₂, 1012ₙ); and
a controller (1020) in communication with the plurality of CMDs (1014₁, 1014₂, 1014ₙ),
wherein each of the plurality of CMDs comprises circuitry configured to execute operations for causing the CMD to repeatedly:
obtain, using a voltage sensor, voltage measurements of the electric battery cell, at a sampling rate,
calculate a rate of change for voltage based on the voltage measurements relative to the sampling rate, and
transmit the voltage measurements and the calculated rate of change to the controller;
wherein, for each of the plurality of CMDs, the controller is configured to:
evaluate the received voltage measurements and rate of change using a model, defined for the electric battery cell according to a manufacturing specification of the electric battery cell, to determine whether the electric battery cell deviated from the manufacturing specification, or reached a predetermined stage of maturation for removing the electric battery cell from the controlled environment, the model comprising one or more voltage-dependent functions, the one or more functions comprising a function for defining a state of maturation of the electric battery cell in which a probability of the electric battery cell exhibiting a manufacturing fault while continuing to undergo maturation is below a predetermined level, the function used determine that the electric cell reached the predetermined stage of maturation; and
generate, upon determining that the electric battery cell reached the predetermined stage of maturation for removing the electric battery cell from the controlled environment, a corresponding alert.

13. The CMS of claim 12,
wherein, for each of the plurality of CMDs (1014₁, 1014₂, 1014ₙ), the circuitry of the CMD is configured to execute operations for causing the CMD to obtain one or more property measurements of a property of the electric battery cell, in addition to voltage, using a corresponding sensor, the electric battery cell having a plurality of properties including voltage, and transmit the obtained one or more property measurements to the controller; and
wherein the controller is configured to evaluate the received one or more property measurements using the model to determine whether the electric battery cell deviated from the manufacturing specification, the model comprising at least one property-dependent functions corresponding to the property.

14. The CMS of claim 13, wherein, for each of the plurality of CMDs (1014₁, 1014₂, 1014ₙ), the circuitry of the CMD is configured to execute operations for causing the CMD to obtain and transmit to the controller (1020) the one or more property measurements for different properties of the electric battery cells in addition to voltage.

15. The CMS of claim 14, wherein, for each of the plurality of CMDs (1014₁, 1014₂, 1014ₙ), the circuitry is configured to execute operations for causing the CMD to repeatedly obtain and transmit to the controller the one or more property measurements.

## Patentansprüche

1. Zellüberwachungsvorrichtung, CMD (100), zur Verwendung mit einer elektrischen Batteriezelle, während die elektrische Batteriezelle elektrisch an die CMD (100) gekoppelt ist und Reifung in einer kontrollierten Umgebung unterzogen wird, nachdem sie geladen ist, wobei die CMD (100) eine Schaltung umfasst, die dazu konfiguriert ist, Vorgänge auszuführen, um zu bewirken, dass die CMD (100) Folgendes wiederholt:
Erhalten (205), unter Verwendung eines Spannungssensors, von Spannungsmessungen der elektrischen Batteriezelle mit einer Abtastrate,
Berechnen (210) einer Änderungsrate für Spannung basierend auf den Spannungsmessungen relativ zu der Abtastrate, und
Evaluieren (215, 220) der erhaltenen Spannungsmessungen und der berechneten Änderungsrate unter Verwendung eines Modells, das für die elektrische Batteriezelle gemäß einer Herstellungsspezifikation der elektrischen Batteriezelle definiert ist, um zu bestimmen (225, 230), ob die elektrische Batteriezelle von der Herstellungsspezifikation abgewichen ist oder eine vorbestimmte Reifephase zum Entfernen der elektrischen Batteriezelle aus der kontrollierten Umgebung erreicht hat, wobei das Modell eine oder mehrere spannungsabhängige Funktionen umfasst, wobei die eine oder mehreren Funktionen eine Funktion zum Definieren eines Reifezustands der elektrischen Batteriezelle umfassen, in dem eine Wahrscheinlichkeit, dass die elektrische Batteriezelle einen Herstellungsfehler zeigt, während sie weiter Reifung unterzogen wird, unter einem vorbestimmten Niveau ist, wobei die Funktion verwendet wird, bestimmen, dass die elektrische Zelle die vorbestimmte Reifephase erreicht hat; und
dazu, eine entsprechende Warnung zu erzeugen (235), wenn bestimmt ist, dass die elektrische Batteriezelle die vorbestimmte Reifephase zum Entfernen der elektrischen Batteriezelle aus der kontrollierten Umgebung erreicht hat.

2. CMD nach Anspruch 1, wobei die Funktion zum Definieren des Reifezustands einen Bereich für eine zweite Ableitung der Spannung der elektrischen Batteriezelle im Zeitverlauf umfasst.

3. CMD nach Anspruch 2, wobei die Schaltung dazu konfiguriert ist, Vorgänge auszuführen, um zu bewirken, dass die CMD bestimmt, dass die elektrische Batterie die vorbestimmte Reifephase erreicht hat, wenn bestimmt ist, dass die zweite Ableitung der Spannung im Zeitverlauf der elektrischen Batteriezellen innerhalb des Bereichs für die zweite Ableitung ist, der durch die entsprechende Funktion definiert ist, und dass die elektrische Batteriezelle nicht von der Herstellungsspezifikation abgewichen ist.

4. CMD nach einem der Ansprüche 1 bis 3, wobei das Modell zumindest eines von Folgendem umfasst:
einer spannungsabhängigen Funktion, die erwartete Spannungsänderungen der elektrischen Batteriezelle definiert, die eine Reifung wie erwartet angeben, wenn sie durch die elektrische Batteriezelle, die Reifung unterzogen wird, gezeigt werden,
einer spannungsabhängigen Funktion, die einen oder mehrere Spannungsschwellenwerte definiert, die einen Herstellungsfehler an der elektrischen Batteriezelle angeben, wenn sie durch die Spannung der elektrischen Batteriezelle unter-/überschritten werden,
einer spannungsabhängigen Funktion, die Spannungsänderungen definiert, die einen Herstellungsfehler an der elektrischen Batteriezelle angeben, wenn sie durch die Spannung der elektrischen Batteriezelle gezeigt werden,
einer spannungsabhängigen Funktion, die erwartete Änderungen einer Änderungsrate der Spannung definiert, die eine Reifung wie erwartet angeben, wenn sie durch die elektrische Batteriezelle, die Reifung unterzogen wird, gezeigt werden,
einer spannungsabhängigen Funktion, die einen oder mehrere Ratenschwellenwerte definiert, die einen Herstellungsfehler angeben, wenn sie durch die Änderungsrate der Spannung der elektrischen Batteriezelle unter-/überschritten werden, oder
einer spannungsabhängigen Funktion, die Änderungen der Änderungsrate der Spannung definiert, die einen Herstellungsfehler an der elektrischen Batteriezelle angeben, wenn sie durch die Änderungsrate der Spannung der elektrischen Batteriezelle gezeigt werden.

5. CMD nach Anspruch 4, wobei das Modell eine oder mehrere Toleranzen umfasst, die für zumindest eine der spannungsabhängigen Funktionen definiert sind, die verwendet werden, wenn die Spannungsmessungen oder die berechnete Änderungsrate evaluiert werden,
wobei optional die eine oder mehreren Toleranzen, die für die zumindest eine spannungsabhängige Funktion definiert sind, zeitabhängig relativ zu der elektrischen Batteriezelle, die Reifung unterzogen wird, und/oder einstellbar basierend auf einem Zustand der kontrollierten Umgebung sind.

6. CMD nach einem der Ansprüche 1 bis 5, wobei die Schaltung dazu konfiguriert ist, Vorgänge auszuführen, um die CMD (100) zu Folgendem zu veranlassen:
Erhalten einer oder mehrerer Eigenschaftsmessungen einer Eigenschaft der elektrischen Batteriezelle zusätzlich zu Spannung unter Verwendung eines entsprechenden Sensors, wobei die elektrische Batteriezelle eine Vielzahl von Eigenschaften, die Spannung enthalten, aufweist; und
Evaluieren der einen oder mehreren erhaltenen Eigenschaftsmessungen unter Verwendung des Modells, um zu bestimmen, ob die elektrische Batteriezelle von der Herstellungsspezifikation abgewichen ist, wobei das Modell zumindest eine eigenschaftsabhängige Funktion entsprechend der Eigenschaft umfasst.

7. CMD nach Anspruch 6, wobei die Schaltung dazu konfiguriert ist, Vorgänge auszuführen, um die CMD (100) zu veranlassen, die eine oder mehreren Eigenschaftsmessungen für verschiedene Eigenschaften der elektrischen Batteriezellen zusätzlich zu Spannung zu erhalten und zu evaluieren,
wobei optional die Schaltung dazu konfiguriert ist, Vorgänge auszuführen, um die CMD (100) zu veranlassen, die eine oder mehreren Eigenschaftsmessungen wiederholt zu erhalten und zu evaluieren.

8. CMD (100) nach einem der Ansprüche 1 bis 7, wobei die CMD (100) zu Folgendem konfiguriert ist: Einbetten in die elektrische Batteriezelle, Anbringen an der elektrischen Batteriezelle oder anschließende Entfernung von der elektrischen Batteriezelle.

9. CMD nach einem der Ansprüche 1 bis 8, wobei die CMD (100) dazu konfiguriert ist, die einzige elektrische Last der elektrischen Batteriezelle zu sein, während die elektrische Batteriezelle Reifung in der kontrollierten Umgebung unterzogen wird.

10. CMD nach einem der Ansprüche 1 bis 9, umfassend einen Speicher, wobei:
die Schaltung dazu konfiguriert ist, Funktionen auszuführen, um die CMD (100) zu veranlassen, Eigenschaftsmessungen, die an der elektrischen Batteriezelle erhalten werden, und resultierende Berechnungen in dem Speicher der CMD (100) für späteren Abruf durch die CMD (100) oder eine Fernsteuerung zu speichern, einschließlich nachdem die elektrische Batteriezelle die vorbestimmte Reifephase erreicht hat; und/oder
das Modell in dem Speicher der CMD (100) gespeichert ist.

11. Zellüberwachungssystem, CMS, zur Verwendung mit einer Vielzahl von elektrischen Batteriezellen, während die Vielzahl von elektrischen Batteriezellen Reifung in einer kontrollierten Umgebung unterzogen wird, nachdem sie geladen ist, wobei die CMS Folgendes umfasst:
eine Vielzahl von CMDs (100) nach einem der Ansprüche 1 bis 11, wobei jede CMD (100) dazu konfiguriert ist, elektrisch an eine aus der Vielzahl von elektrischen Batteriezellen gekoppelt zu sein; und
eine Steuerung (130) in Kommunikation mit der Vielzahl von CMDs (100),
wobei jede CMD (100) dazu konfiguriert ist, wenn bestimmt ist, dass die entsprechende elektrische Batteriezelle von der Herstellungsspezifikation abgewichen ist oder die vorbestimmte Reifephase erreicht hat, die entsprechende Warnung an die Steuerung zu übertragen.

12. Zellüberwachungssystem, CMS, zur Verwendung mit einer Vielzahl von elektrischen Batteriezellen, während die Vielzahl von elektrischen Batteriezellen Reifung in einer kontrollierten Umgebung unterzogen wird, nachdem sie geladen ist, wobei das CMS Folgendes umfasst:
eine Vielzahl von Zellüberwachungsvorrichtungen, CMDs (1014₁, 1014₂, 1014ₙ), wobei jede CMD dazu konfiguriert ist, elektrisch an eine aus der Vielzahl von elektrischen Batteriezellen (1012₁, 1012₂, 1012ₙ) gekoppelt zu sein; und
eine Steuerung (1020) in Kommunikation mit der Vielzahl von CMDs (1014₁, 1014₂, 1014ₙ),
wobei jede aus der Vielzahl von CMDs eine Schaltung umfasst, die dazu konfiguriert ist, Vorgänge auszuführen, um die CMD wiederholt zu Folgendem zu veranlassen:
Erhalten, unter Verwendung eines Spannungssensors, von Spannungsmessungen der elektrischen Batteriezelle mit einer Abtastrate,
Berechnen einer Änderungsrate für Spannung basierend auf den Spannungsmessungen relativ zu der Abtastrate, und
Übertragen der Spannungsmessungen und der berechneten Änderungsrate an die Steuerung; wobei für jede aus der Vielzahl von CMDs die Steuerung zu Folgendem konfiguriert ist:
Evaluieren der empfangenen Spannungsmessungen und Änderungsrate unter Verwendung eines Modells, das für die elektrische Batteriezelle gemäß einer Herstellungsspezifikation der elektrischen Batteriezelle definiert ist, um zu bestimmen, ob die elektrische Batteriezelle von der Herstellungsspezifikation abgewichen ist oder eine vorbestimmte Reifephase zum Entfernen der elektrischen Batteriezelle aus der kontrollierten Umgebung erreicht hat, wobei das Modell eine oder mehrere spannungsabhängige Funktionen umfasst, wobei die eine oder mehreren Funktionen eine Funktion zum Definieren eines Reifezustands der elektrischen Batteriezelle umfassen, in dem eine Wahrscheinlichkeit, dass die elektrische Batteriezelle einen Herstellungsfehler aufweist, während sie weiter Reifung unterzogen wird, unter einem vorbestimmten Niveau ist, wobei die Funktion verwendet wird, bestimmen, dass die elektrische Zelle die vorbestimmte Reifephase erreicht hat; und
Erzeugen einer entsprechenden Warnung, wenn bestimmt ist, dass die elektrische Batteriezelle die vorbestimmte Reifephase zum Entfernen der elektrischen Batteriezelle aus der kontrollierten Umgebung erreicht hat.

13. CMS nach Anspruch 12,
wobei für jede aus der Vielzahl von CMDs (1014₁, 1014₂, 1014ₙ) die Schaltung der CMD dazu konfiguriert ist, Vorgänge auszuführen, um die CMD zu veranlassen, eine oder mehrere Eigenschaftsmessungen einer Eigenschaft der elektrischen Batteriezelle zusätzlich zu Spannung unter Verwendung eines entsprechenden Sensors zu erhalten, wobei die elektrische Batteriezelle eine Vielzahl von Eigenschaften, die Spannung enthalten, aufweist, und die eine oder mehreren erhaltenen Eigenschaftsmessungen an die Steuerung zu übertragen; und
wobei die Steuerung dazu konfiguriert ist, die eine oder mehreren empfangenen Eigenschaftsmessungen unter Verwendung des Modells zu evaluieren, um zu bestimmen, ob die elektrische Batteriezelle von der Herstellungsspezifikation abgewichen ist, wobei das Modell zumindest eine eigenschaftsabhängige Funktionen entsprechend der Eigenschaft umfasst.

14. CMS nach Anspruch 13, wobei für jede aus der Vielzahl von CMDs (1014₁, 1014₂, 1014ₙ) die Schaltung der CMD dazu konfiguriert ist, Vorgänge auszuführen, um die CMD zu veranlassen, die eine oder mehreren Eigenschaftsmessungen für verschiedene Eigenschaften der elektrischen Batteriezellen zusätzlich zu Spannung zu erhalten und an die Steuerung (1020) zu übertragen.

15. CMS nach Anspruch 14, wobei für jede aus der Vielzahl von CMDs (1014₁, 1014₂, 1014ₙ) die Schaltung dazu konfiguriert ist, Vorgänge auszuführen, um die CMD zu veranlassen, die eine oder mehreren Eigenschaftsmessungen wiederholt zu erhalten und an die Steuerung zu übertragen.

## Revendications

1. Dispositif de surveillance de cellule, CMD (100), destiné à être utilisé avec une cellule de batterie électrique tandis que la cellule de batterie électrique est couplée électriquement au CMD (100) et subit une maturation dans un environnement contrôlé, après avoir été chargée, le CMD (100) comprenant des circuits configurés pour exécuter des opérations pour amener le CMD (100) à, de manière répétée :
obtenir (205), à l'aide d'un capteur de tension, des mesures de tension de la cellule de batterie électrique, à un taux d'échantillonnage,
calculer (210) un taux de changement pour la tension sur la base des mesures de tension par rapport au taux d'échantillonnage, et
évaluer (215, 220) les mesures de tension obtenues et le taux de changement calculé à l'aide d'un modèle défini pour la cellule de batterie électrique selon une spécification de fabrication de la cellule de batterie électrique, pour déterminer (225, 230) si la cellule de batterie électrique s'est écartée de la spécification de fabrication, ou a atteint un stade prédéterminé de maturation pour retirer la cellule de batterie électrique de l'environnement contrôlé, le modèle comprenant une ou plusieurs fonctions dépendantes de la tension, l'une ou plusieurs fonctions comprenant une fonction de définition d'un état de maturation de la cellule de batterie électrique dans lequel une probabilité que la cellule de batterie électrique présente un défaut de fabrication tandis qu'elle continue à subir une maturation est inférieure à un niveau prédéterminé, la fonction étant utilisée pour déterminer que la cellule électrique a atteint le stade prédéterminé de maturation ; et
générer (235), lors de la détermination que la cellule de batterie électrique a atteint le stade prédéterminé de maturation pour retirer la cellule de batterie électrique de l'environnement contrôlé, une alerte correspondante.

2. CMD de la revendication 1, dans lequel la fonction de définition de l'état de maturation comprend une plage pour une dérivée seconde de la tension de l'élément de batterie électrique par rapport au temps.

3. CMD de la revendication 2, dans lequel les circuits sont configurés pour exécuter des opérations pour amener le CMD à déterminer que la batterie électrique a atteint le stade prédéterminé de maturation lors de la détermination que la dérivée seconde de la tension par rapport au temps des cellules de batterie électrique se situe dans la plage pour la dérivée seconde définie par la fonction correspondante et que la cellule de batterie électrique ne s'est pas écartée de la spécification de fabrication.

4. CMD de l'une quelconque des revendications 1 à 3, dans lequel le modèle comprend au moins l'une parmi :
une fonction dépendante de la tension définissant des changements attendus de tension de la cellule de batterie électrique, indicatifs de la maturation telle qu'attendue, lorsqu'ils sont présentés par la cellule de batterie électrique subissant une maturation,
une fonction dépendante de la tension définissant un ou plusieurs seuils de tension, indicatifs d'un défaut de fabrication au niveau de la cellule de batterie électrique, lorsqu'ils sont franchis par la tension de la cellule de batterie électrique,
une fonction dépendante de la tension définissant des changements de tension, indicatifs d'un défaut de fabrication au niveau de l'élément de batterie électrique, lorsqu'ils sont présentés par la tension de la cellule de batterie électrique,
une fonction dépendante de la tension définissant des changements attendus dans un taux de changement de tension, indicatifs de la maturation telle qu'attendue, lorsqu'ils sont présentés par la cellule de batterie électrique en cours de maturation,
une fonction dépendante de la tension définissant un ou plusieurs seuils de taux, indicatifs d'un défaut de fabrication, lorsqu'ils sont franchis par le taux de changement de la tension de la cellule de batterie électrique, ou
une fonction dépendante de la tension définissant des changements dans le taux de changement de tension, indicatifs d'un défaut de fabrication au niveau de la cellule de batterie électrique, lorsqu'ils sont présentés par le taux de changement de tension de la cellule de batterie électrique.

5. CMD de la revendication 4, dans lequel le modèle comprend une ou plusieurs tolérances définies pour au moins l'une des fonctions dépendantes de la tension utilisées lors de l'évaluation des mesures de tension ou du taux de changement calculé,
éventuellement dans lequel l'une ou plusieurs tolérances définies pour l'au moins une fonction dépendante de la tension sont dépendantes du temps par rapport à la cellule de batterie électrique subissant une maturation et/ou ajustables en fonction d'un état de l'environnement contrôlé.

6. CMD de l'une quelconque des revendications 1 à 5, dans lequel les circuits sont configurés pour exécuter des opérations pour amener le CMD (100) à :
obtenir une ou plusieurs mesures de propriété d'une propriété de la cellule de batterie électrique, en plus de la tension, à l'aide d'un capteur correspondant, la cellule de batterie électrique ayant une pluralité de propriétés, comprenant la tension ; et
évaluer l'une ou plusieurs mesures de propriété obtenues à l'aide du modèle pour déterminer si la cellule de batterie électrique s'est écartée de la spécification de fabrication, le modèle comprenant au moins une fonction dépendante de la propriété correspondant à la propriété.

7. CMD de la revendication 6, dans lequel les circuits sont configurés pour exécuter des opérations pour amener le CMD (100) à obtenir et à évaluer l'une ou plusieurs mesures de propriété pour différentes propriétés des cellules de batterie électrique en plus de la tension,
éventuellement dans lequel les circuits sont configurés pour exécuter des opérations pour amener le CMD (100) à obtenir et évaluer, de manière répétée, l'une ou plusieurs mesures de propriété.

8. CMD (100) de l'une quelconque des revendications 1 à 7, dans lequel le CMD (100) est configuré pour : l'encastrement dans la cellule de batterie électrique, la fixation à la cellule de batterie électrique, ou le retrait ultérieur de la cellule de batterie électrique.

9. CMD de l'une quelconque des revendications 1 à 8, dans lequel le CMD (100) est configuré pour être la seule charge électrique de la cellule de batterie électrique tandis que la cellule de batterie électrique subit une maturation dans l'environnement contrôlé.

10. CMD de l'une quelconque des revendications 1 à 9, comprenant une mémoire, dans lequel :
les circuits sont configurés pour exécuter des fonctions pour amener le CMD (100) à stocker des mesures de propriété obtenues au niveau de la cellule de batterie électrique et des calculs résultants dans la mémoire du CMD (100) pour une récupération ultérieure par le CMD (100) ou une télécommande, y compris après que la cellule de batterie électrique a atteint le stade prédéterminé de maturation ; et/ou
le modèle est stocké dans la mémoire du CMD (100).

11. Système de surveillance de cellule, CMS, destiné à être utilisé avec une pluralité de cellules de batterie électrique tandis que la pluralité de cellules de batterie électrique subissent une maturation dans un environnement contrôlé, après avoir été chargées, le CMS comprenant :
une pluralité de CMD (100) de l'une quelconque des revendications 1 à 11, chaque CMD (100) étant configuré pour être couplé électriquement à l'une de la pluralité de cellules de batterie électrique ; et
un contrôleur (130) en communication avec la pluralité de CMD (100),
dans lequel chaque CMD (100) est configuré, lors de la détermination que la cellule de batterie électrique correspondante s'est écartée de la spécification de fabrication ou a atteint le stade prédéterminé de maturation, pour transmettre l'alerte correspondante au contrôleur.

12. Système de surveillance de cellule, CMS, destiné à être utilisé avec une pluralité de cellules de batterie électrique tandis que la pluralité de cellules de batterie électrique subissent une maturation dans un environnement contrôlé, après avoir été chargées,
le CMS comprenant :
une pluralité de dispositifs de surveillance de cellules, CMD (1014₁, 1014₂, 1014ₙ), chaque CMD étant configuré pour être couplé électriquement à l'une de la pluralité de cellules de batterie électrique (1012₁, 1012₂, 1012ₙ) ; et
un contrôleur (1020) en communication avec la pluralité de CMD (1014₁, 1014₂, 1014ₙ),
dans lequel chacun de la pluralité de CMD comprend des circuits configurés pour exécuter des opérations pour amener le CMD à, de manière répétée :
obtenir, à l'aide d'un capteur de tension, des mesures de tension de la cellule de batterie électrique, à un taux d'échantillonnage,
calculer un taux de changement pour la tension sur la base des mesures de tension par rapport au taux d'échantillonnage, et
transmettre les mesures de tension et le taux de changement calculé au contrôleur ; dans lequel, pour chacun de la pluralité de CMD, le contrôleur est configuré pour :
évaluer les mesures de tension reçues et le taux de changement à l'aide d'un modèle, défini pour la cellule de batterie électrique selon une spécification de fabrication de la cellule de batterie électrique, pour déterminer si la cellule de batterie électrique s'est écartée de la spécification de fabrication, ou a atteint un stade prédéterminé de maturation pour retirer la cellule de batterie électrique de l'environnement contrôlé, le modèle comprenant une ou plusieurs fonctions dépendantes de la tension, l'une ou plusieurs fonctions comprenant une fonction pour définir un état de maturation de la cellule de batterie électrique dans lequel une probabilité que la cellule de batterie électrique présente un défaut de fabrication tandis qu'elle continue à subir une maturation est inférieure à un niveau prédéterminé, la fonction étant utilisée pour déterminer que la cellule électrique a atteint le stade prédéterminé de maturation ; et
générer, lors de la détermination que la cellule de batterie électrique a atteint le stade prédéterminé de maturation pour retirer la cellule de batterie électrique de l'environnement contrôlé, une alerte correspondante.

13. CMS de la revendication 12,
dans lequel, pour chacun de la pluralité de CMD (1014₁, 1014₂, 1014ₙ), les circuits du CMD sont configurés pour exécuter des opérations pour amener le CMD à obtenir une ou plusieurs mesures de propriété d'une propriété de la cellule de batterie électrique, en plus de la tension, à l'aide d'un capteur correspondant, la cellule de batterie électrique ayant une pluralité de propriétés, comprenant la tension, et transmettre l'une ou plusieurs mesures de propriétés obtenues au contrôleur ; et
dans lequel le contrôleur est configuré pour évaluer l'une ou plusieurs mesures de propriété reçues à l'aide du modèle pour déterminer si la cellule de batterie électrique s'est écartée de la spécification de fabrication, le modèle comprenant au moins une fonction dépendante de la propriété correspondant à la propriété.

14. CMS de la revendication 13, dans lequel, pour chacun de la pluralité de CMD (1014₁, 1014₂, 1014ₙ), les circuits du CMD sont configurés pour exécuter des opérations pour amener le CMD à obtenir et à transmettre au contrôleur (1020) l'une ou plusieurs mesures de propriété pour différentes propriétés des cellules de batterie électrique en plus de la tension.

15. CMS de la revendication 14, dans lequel, pour chacun de la pluralité de CMD (1014₁, 1014₂, 1014ₙ), les circuits sont configurés pour exécuter des opérations pour amener le CMD à obtenir et à transmettre, de manière répétée, au contrôleur l'une ou plusieurs mesures de propriété.
